(19) **Europäisches Patentamt / European Patent Office / Office européen des brevets**

(11) **EP 4 141 938 A1**

(12) **EUROPEAN PATENT APPLICATION**
published in accordance with Art. 153(4) EPC

(43) Date of publication:
**01.03.2023 Bulletin 2023/09**

(21) Application number: **21793193.0**

(22) Date of filing: **14.04.2021**

(51) International Patent Classification (IPC):
**H01L 27/144** (2006.01)   **H01L 27/146** (2006.01)
**H04N 5/33** (2006.01)

(52) Cooperative Patent Classification (CPC):
**H01L 27/144; H01L 27/146; H04N 5/33**

(86) International application number:
**PCT/JP2021/015499**

(87) International publication number:
**WO 2021/215337 (28.10.2021 Gazette 2021/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.04.2020   JP 2020074995**

(71) Applicant: **Sony Semiconductor Solutions Corporation**
**Atsugi-shi Kanagawa 243-0014 (JP)**

(72) Inventors:
• **MASUDA, Yoshiaki**
  **Atsugi-shi, Kanagawa 243-0014 (JP)**
• **YAMASHITA, Kazuyoshi**
  **Atsugi-shi, Kanagawa 243-0014 (JP)**
• **KURIHARA, Shinichiro**
  **Atsugi-shi, Kanagawa 243-0014 (JP)**
• **KUROGI, Syogo**
  **Kikuchi-gun, Kumamoto 869-1102 (JP)**

• **UESAKA, Yusuke**
  **Atsugi-shi, Kanagawa 243-0014 (JP)**
• **SAKAMOTO, Toshiki**
  **Kikuchi-gun, Kumamoto 869-1102 (JP)**
• **KAWANO, Hiroyuki**
  **Kikuchi-gun, Kumamoto 869-1102 (JP)**
• **IWAMOTO, Masatoshi**
  **Kikuchi-gun, Kumamoto 869-1102 (JP)**
• **TERADA, Takashi**
  **Kikuchi-gun, Kumamoto 869-1102 (JP)**
• **NAKAJIKI, Sintaro**
  **Kikuchi-gun, Kumamoto 869-1102 (JP)**
• **KOBAYASHI, Shinta**
  **Atsugi-shi, Kanagawa 243-0014 (JP)**
• **ARAI, Chihiro**
  **Atsugi-shi, Kanagawa 243-0014 (JP)**

(74) Representative: **MFG Patentanwälte Meyer-Wildhagen Meggle-Freund Gerhard PartG mbB**
**Amalienstraße 62**
**80799 München (DE)**

(54) **SOLID-STATE IMAGING ELEMENT AND ELECTRONIC DEVICE**

(57)   A solid-state imaging element according to the present disclosure includes a first light receiving pixel, a second light receiving pixel, and a metal layer (34). The first light receiving pixel receives visible light. The second light receiving pixel receives infrared light. The metal layer (34) is provided to face at least one of a photoelectric conversion unit of the first light receiving pixel and a photoelectric conversion unit of the second light receiving pixel on an opposite side of a light incident side, and contains tungsten as a main component.

EP 4 141 938 A1

# FIG.4

**Description**

Field

The present disclosure relates to a solid-state imaging element and an electronic device.

Background

In recent years, a solid-state imaging element capable of simultaneously acquiring a visible light image and an infrared image has been known. In such a solid-state imaging element, a light receiving pixel that receives visible light and a light receiving pixel that receives infrared light are formed side by side in the same pixel array unit (see, for example, Patent Literature 1).

Citation List

Patent Literature

Patent Literature 1: JP 2017-139286 A

Summary

Technical Problem

However, in a case where a visible light receiving pixel and an infrared light receiving pixel are formed in the same pixel array unit, infrared light incident on the infrared light receiving pixel may leak to an adjacent light receiving pixel, and color mixture may occur in the adjacent light receiving pixel.
Therefore, the present disclosure proposes a solid-state imaging element and an electronic device capable of suppressing occurrence of color mixing.

Solution to Problem

According to the present disclosure, there is provided a solid-state imaging element. The solid-state imaging element includes a first light receiving pixel, a second light receiving pixel, and a metal layer. The first light receiving pixel receives visible light. The second light receiving pixel receives infrared light. The metal layer is provided to face at least one of a photoelectric conversion unit of the first light receiving pixel and a photoelectric conversion unit of the second light receiving pixel on an opposite side of a light incident side, and contains tungsten as a main component.

Brief Description of Drawings

FIG. 1 is a system configuration diagram illustrating a schematic configuration example of a solid-state imaging element according to an embodiment of the present disclosure.
FIG. 2 is a plan view illustrating an example of a pixel array unit according to an embodiment of the present disclosure.
FIG. 3 is a plan view illustrating another example of the pixel array unit according to an embodiment of the present disclosure.
FIG. 4 is a cross-sectional view schematically illustrating a structure of the pixel array unit according to an embodiment of the present disclosure.
FIG. 5 is a view for explaining a function of a metal layer according to an embodiment of the present disclosure.
FIG. 6 is a view illustrating a relationship between a cell size and a color mixing ratio in a pixel array unit of a reference example.
FIG. 7 is a cross-sectional view schematically illustrating a structure of a pixel array unit according to a first modification of the embodiment of the present disclosure.
FIG. 8 is a cross-sectional view schematically illustrating a structure of a pixel array unit according to a second modification of the embodiment of the present disclosure.
FIG. 9 is a view for explaining a function of a metal layer according to the second modification of the embodiment of the present disclosure.
FIG. 10 is a cross-sectional view schematically illustrating a structure of a pixel array unit according to a third modification of the embodiment of the present disclosure.

FIG. 11 is a plan view illustrating an example of a configuration and arrangement of the metal layer according to an embodiment of the present disclosure.

FIG. 12 is a plan view illustrating another example of the configuration and arrangement of the metal layer according to an embodiment of the present disclosure.

FIG. 13 is a cross-sectional view schematically illustrating a structure of a pixel array unit according to a fourth modification of the embodiment of the present disclosure.

FIG. 14 is a plan view illustrating an example of a configuration and arrangement of a metal layer according to the fourth modification of the embodiment of the present disclosure.

FIG. 15 is a cross-sectional view schematically illustrating a structure of a pixel array unit according to a fifth modification of the embodiment of the present disclosure.

FIG. 16 is a plan view illustrating an example of a metal layer according to the fifth modification of the embodiment of the present disclosure.

FIG. 17 is a plan view illustrating an example of a metal layer according to the fifth modification of the embodiment of the present disclosure.

FIG. 18 is a plan view illustrating an example of the metal layer according to the fifth modification of the embodiment of the present disclosure.

FIG. 19 is a cross-sectional view schematically illustrating a structure of a pixel array unit according to a sixth modification of the embodiment of the present disclosure.

FIG. 20 is a cross-sectional view schematically illustrating a structure of a pixel array unit according to a seventh modification of the embodiment of the present disclosure.

FIG. 21 is a cross-sectional view schematically illustrating a structure of a pixel array unit according to an eighth modification of the embodiment of the present disclosure.

FIG. 22 is a cross-sectional view schematically illustrating a structure of a pixel array unit according to a ninth modification of the embodiment of the present disclosure.

FIG. 23 is a cross-sectional view schematically illustrating a structure of a pixel array unit according to a 10th modification of the embodiment of the present disclosure.

FIG. 24 is a cross-sectional view schematically illustrating a structure of a pixel array unit according to an 11th modification of the embodiment of the present disclosure.

FIG. 25 is a cross-sectional view schematically illustrating a structure of a pixel array unit according to a 12th modification of the embodiment of the present disclosure.

FIG. 26 is a cross-sectional view schematically illustrating a structure of a pixel array unit according to a 13th modification of the embodiment of the present disclosure.

FIG. 27 is a cross-sectional view schematically illustrating a structure of a pixel array unit according to a 14th modification of the embodiment of the present disclosure.

FIG. 28 is a view illustrating an example of a spectral characteristic of an IR cut filter according to an embodiment of the present disclosure.

FIG. 29 is a view illustrating an example of a spectral characteristic of each unit pixel according to an embodiment of the present disclosure.

FIG. 30 is a view illustrating an example of a coloring material of the IR cut filter according to an embodiment of the present disclosure.

FIG. 31 is a view illustrating another example of a spectral characteristic of the IR cut filter according to an embodiment of the present disclosure.

FIG. 32 is a view illustrating another example of a spectral characteristic of the IR cut filter according to an embodiment of the present disclosure.

FIG. 33 is a view illustrating another example of a spectral characteristic of the IR cut filter according to an embodiment of the present disclosure.

FIG. 34 is a view illustrating another example of a spectral characteristic of the IR cut filter according to an embodiment of the present disclosure.

FIG. 35 is a cross-sectional view schematically illustrating a structure of a pixel array unit according to a 15th modification of the embodiment of the present disclosure.

FIG. 36 is a cross-sectional view schematically illustrating a structure of a pixel array unit according to a 16th modification of the embodiment of the present disclosure.

FIG. 37 is a cross-sectional view schematically illustrating a structure of a pixel array unit according to a 17th modification of the embodiment of the present disclosure.

FIG. 38 is a cross-sectional view schematically illustrating a structure of a pixel array unit according to an 18th modification of the embodiment of the present disclosure.

FIG. 39 is a cross-sectional view schematically illustrating a structure of a pixel array unit according to a 19th modification of the embodiment of the present disclosure.

FIG. 40 is a cross-sectional view schematically illustrating a structure of a pixel array unit according to a 20th modification of the embodiment of the present disclosure.

FIG. 41 is a cross-sectional view schematically illustrating a structure of a pixel array unit according to a 21st modification of the embodiment of the present disclosure.

FIG. 42 is a cross-sectional view schematically illustrating a structure of a pixel array unit according to a 22nd modification of the embodiment of the present disclosure.

FIG. 43 is a cross-sectional view schematically illustrating a structure of a pixel array unit according to a 23rd modification of the embodiment of the present disclosure.

FIG. 44 is a cross-sectional view schematically illustrating a structure of a pixel array unit according to a 24th modification of the embodiment of the present disclosure.

FIG. 45 is a cross-sectional view schematically illustrating a structure of a pixel array unit according to a 25th modification of the embodiment of the present disclosure.

FIG. 46 is a cross-sectional view schematically illustrating a structure of a pixel array unit according to a 26th modification of the embodiment of the present disclosure.

FIG. 47 is a cross-sectional view schematically illustrating a structure of a pixel array unit according to a 27th modification of the embodiment of the present disclosure.

FIG. 48 is a plan view schematically illustrating an example of arrangement of protrusion portions according to the 27th modification of the embodiment of the present disclosure.

FIG. 49 is a plan view schematically illustrating an example of arrangement of the protrusion portions according to the 27th modification of the embodiment of the present disclosure.

FIG. 50 is a plan view schematically illustrating an example of arrangement of the protrusion portions according to the 27th modification of the embodiment of the present disclosure.

FIG. 51 is a plan view schematically illustrating an example of arrangement of the protrusion portions according to the 27th modification of the embodiment of the present disclosure.

FIG. 52 is a plan view schematically illustrating an example of arrangement of the protrusion portions according to the 27th modification of the embodiment of the present disclosure.

FIG. 53 is a plan view schematically illustrating an example of arrangement of the protrusion portions according to the 27th modification of the embodiment of the present disclosure.

FIG. 54 is a plan view schematically illustrating an example of arrangement of the protrusion portions according to the 27th modification of the embodiment of the present disclosure.

FIG. 55 is a cross-sectional view schematically illustrating a structure of a pixel array unit according to a 28th modification of the embodiment of the present disclosure.

FIG. 56 is a cross-sectional view schematically illustrating a structure of a pixel array unit according to a 29th modification of the embodiment of the present disclosure.

FIG. 57 is a view for explaining an example of a step of manufacturing a metal layer according to the 29th modification of the embodiment of the present disclosure.

FIG. 58 is a view for explaining an example of a step of manufacturing a metal layer according to the 29th modification of the embodiment of the present disclosure.

FIG. 59 is a view for explaining an example of a step of manufacturing a metal layer according to the 29th modification of the embodiment of the present disclosure.

FIG. 60 is a view for explaining an example of a step of manufacturing a metal layer according to the 29th modification of the embodiment of the present disclosure.

FIG. 61 is a view for explaining an example of a step of manufacturing a metal layer according to the 29th modification of the embodiment of the present disclosure.

FIG. 62 is a view for explaining another example of a step of manufacturing the metal layer according to the 29th modification of the embodiment of the present disclosure.

FIG. 63 is a view for explaining another example of a step of manufacturing the metal layer according to the 29th modification of the embodiment of the present disclosure.

FIG. 64 is a view for explaining another example of a step of manufacturing the metal layer according to the 29th modification of the embodiment of the present disclosure.

FIG. 65 is a cross-sectional view schematically illustrating a peripheral structure of the solid-state imaging element according to an embodiment of the present disclosure.

FIG. 66 is a view illustrating a planar configuration of the solid-state imaging element according to an embodiment of the present disclosure.

FIG. 67 is a block view illustrating a configuration example of an imaging device as an electronic device to which the technology according to the present disclosure is applied.

Description of Embodiments

Hereinafter, each embodiments of the present disclosure will be described in detail with reference to the drawings. In each of the following embodiments, the same parts are denoted by the same reference numerals, and redundant description will be omitted.

In recent years, a solid-state imaging element capable of simultaneously acquiring a visible light image and an infrared image has been known. In such a solid-state imaging element, a light receiving pixel that receives visible light and a light receiving pixel that receives infrared light are formed side by side in the same pixel array unit.

However, in a case where a visible light receiving pixel and an infrared light receiving pixel are formed in the same pixel array unit, infrared light incident on the infrared light receiving pixel may leak to an adjacent light receiving pixel, and color mixture may occur in the adjacent light receiving pixel.

This is because infrared light has a longer wavelength than visible light and thus has a longer optical path length, in a manner that infrared light having passed through a photodiode is easily reflected by a lower wiring layer and leaks into an adjacent light receiving pixel.

Therefore, realization of a technique capable of overcoming the above-described problems and suppressing occurrence of color mixing is expected.

<Configuration of solid-state imaging element>

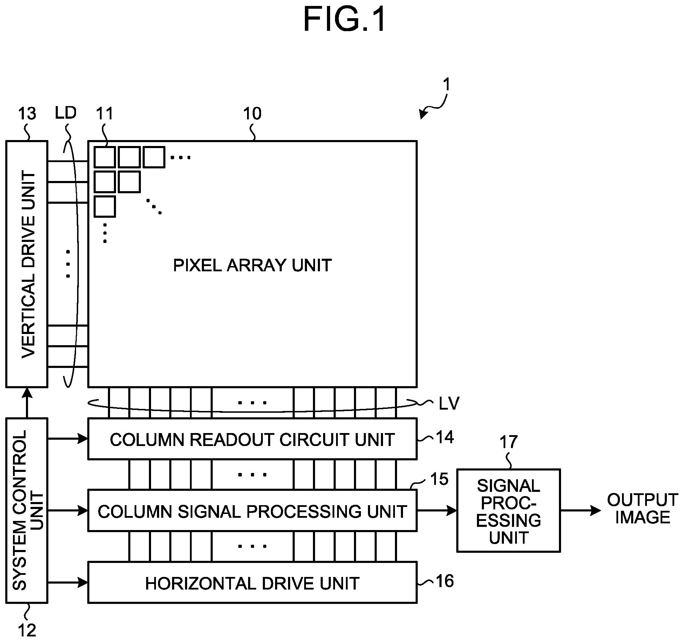

FIG. 1 is a system configuration diagram illustrating a schematic configuration example of a solid-state imaging element 1 according to an embodiment of the present disclosure. As illustrated in FIG. 1, a solid-state imaging element 1 that is a CMOS image sensor includes a pixel array unit 10, a system control unit 12, a vertical drive unit 13, a column readout circuit unit 14, a column signal processing unit 15, a horizontal drive unit 16, and a signal processing unit 17.

The pixel array unit 10, the system control unit 12, the vertical drive unit 13, the column readout circuit unit 14, the column signal processing unit 15, the horizontal drive unit 16, and the signal processing unit 17 are provided on the same semiconductor substrate or on a plurality of electrically connected laminated semiconductor substrates.

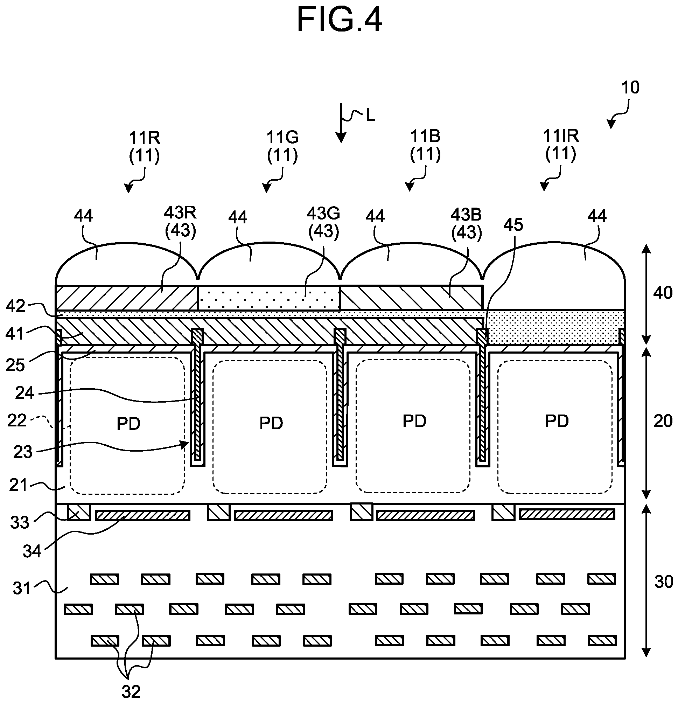

In the pixel array unit 10, effective unit pixels (hereinafter, also referred to as unit pixels) 11 each having a photoelectric conversion element (such as a photodiode PD (see FIG. 4)) capable of photoelectrically converting a charge amount corresponding to an incident light amount, accumulating the charge amount inside, and outputting the charge amount as a signal are two-dimensionally arranged in a matrix.

In addition, in addition to the effective unit pixel 11, the pixel array unit 10 may include a region in which a dummy unit pixel having a structure without a photodiode PD and the like, a light-shielding unit pixel in which light incidence from the outside is shielded by shielding the light-receiving surface, and the like is arranged in a row and/or column.

Note that the light-shielding unit pixel may have the same configuration as the effective unit pixel 11 except for having a structure in which the light-receiving surface is shielded from light. In addition, in the following description, the photocharge of a charge amount corresponding to the incident light amount is also simply referred to as "charge", and the unit pixel 11 is also simply referred to as "pixel".

In the pixel array unit 10, a pixel drive line LD is formed for each row along the left-right direction in the drawing (the array direction of the pixels in the pixel row) with respect to the pixel array in a matrix, and a vertical pixel wiring LV is formed for each column along the up-down direction in the drawing (the array direction of the pixels in the pixel column). One end of the pixel drive line LD is connected to an output terminal corresponding to each row of the vertical drive unit 13.

The column readout circuit unit 14 includes at least a circuit that supplies a constant current to the unit pixel 11 in a selected row in the pixel array unit 10 for each column, a current mirror circuit, a changeover switch of the unit pixel 11 to be read, and the like.

Then, the column readout circuit unit 14 configures an amplifier together with the transistor in the selected pixel in the pixel array unit 10, converts the photocharge signal into a voltage signal, and outputs the voltage signal to the vertical pixel wiring LV.

The vertical drive unit 13 includes a shift register, an address decoder, and the like, and drives each unit pixel 11 of the pixel array unit 10 at the same time for all pixels or in units of rows. Although a specific configuration of the vertical drive unit 13 is not illustrated, the vertical drive unit 13 has a configuration including a readout scanning system and a sweep scanning system or a batch sweep and batch transfer system.

In order to read a pixel signal from the unit pixel 11, the readout scanning system sequentially selects and scans the unit pixel 11 of the pixel array unit 10 in units of rows. In the case of row driving (rolling shutter operation), sweep scanning is performed on a readout row on which readout scanning is performed by the readout scanning system prior to the readout scanning by a time corresponding to a shutter speed.

In addition, in the case of global exposure (global shutter operation), batch sweeping is performed earlier than batch transfer by the time of the shutter speed. By such sweeping, unnecessary charges are swept (reset) from the photodiode PD and the like of the unit pixel 11 in the readout row. Then, so-called electronic shutter operation is performed by sweeping (resetting) unnecessary charges.

Here, the electronic shutter operation refers to an operation of discarding unnecessary photocharges accumulated in the photodiode PD and the like until immediately before and newly starting exposure (starting accumulation of photocharges).

The signal read by the readout operation by the readout scanning system corresponds to the amount of light incident after the immediately preceding readout operation or electronic shutter operation. In the case of the row drive, a period from the readout timing by the immediately preceding readout operation or the sweep timing by the electronic shutter operation to the readout timing by the current readout operation is the photocharge accumulation time (exposure time) in the unit pixel 11. In the case of global exposure, the time from batch sweeping to batch transfer is the accumulation time (exposure time).

The pixel signal output from each unit pixel 11 of the pixel row selectively scanned by the vertical drive unit 13 is supplied to the column signal processing unit 15 through each of the vertical pixel wirings LV. The column signal processing unit 15 performs predetermined signal processing on the pixel signal output from each unit pixel 11 of the selected row through the vertical pixel wiring LV for each pixel column of the pixel array unit 10, and temporarily holds the pixel signal after the signal processing.

Specifically, the column signal processing unit 15 performs at least noise removal processing, for example, correlated double sampling (CDS) processing as signal processing. By the CDS processing by the column signal processing unit 15, fixed pattern noise unique to pixels such as reset noise and threshold variation of the amplification transistor AMP is removed.

Note that the column signal processing unit 15 can be configured to have, for example, an AD conversion function in addition to the noise removal processing and output the pixel signal as a digital signal.

The horizontal drive unit 16 includes a shift register, an address decoder, and the like, and sequentially selects a unit circuit corresponding to a pixel column of the column signal processing unit 15. By the selective scanning by the horizontal drive unit 16, the pixel signals subjected to the signal processing by the column signal processing unit 15 are sequentially output to the signal processing unit 17.

The system control unit 12 includes a timing generator that generates various timing signals and the like, and performs drive control of the vertical drive unit 13, the column signal processing unit 15, the horizontal drive unit 16, and the like based on various timing signals generated by the timing generator.

The solid-state imaging element 1 further includes a signal processing unit 17 and a data storage unit (not illustrated). The signal processing unit 17 has at least an addition processing function, and performs various types of signal processing such as addition processing on the pixel signal output from the column signal processing unit 15.

The data storage unit temporarily stores data necessary for signal processing in the signal processing unit 17. The signal processing unit 17 and the data storage unit may be processed by an external signal processing unit provided on a substrate different from the solid-state imaging element 1, for example, a digital signal processor (DSP) or software, or may be mounted on the same substrate as the solid-state imaging element 1.

<Configuration of pixel array unit>

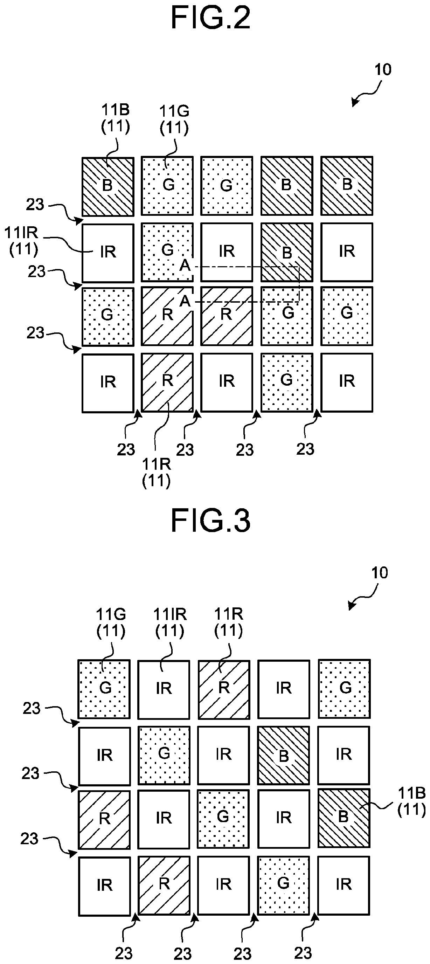

Next, a detailed configuration of the pixel array unit 10 will be described with reference to FIGS. 2 to 5. FIG. 2 is a plan view illustrating an example of the pixel array unit 10 according to an embodiment of the present disclosure.

As illustrated in FIG. 2, in the pixel array unit 10 according to the embodiment, a plurality of unit pixels 11 is arranged side by side in a matrix. The plurality of unit pixels 11 includes an R pixel 11R that receives red light, a G pixel 11G that receives green light, a B pixel 11B that receives blue light, and an IR pixel 11IR that receives infrared light.

The R pixel 11R, the G pixel 11G, and the B pixel 11B are examples of first light receiving pixels, and are also collectively referred to as "visible light pixels" below. In addition, the IR pixel 11IR is an example of a second light receiving pixel.

In addition, a separation region 23 is provided between the adjacent unit pixels 11. The separation regions 23 are arranged in a lattice shape in a plan view in the pixel array unit 10.

In the pixel array unit 10 according to the embodiment, for example, as illustrated in FIG. 2, visible light pixels of the same type may be arranged in an L shape, and IR pixels 11IR may be arranged in the remaining portions.

Note that the arrangement of the visible light pixels and the IR pixels 11IR in the pixel array unit 10 is not limited to the example of FIG. 2. For example, as illustrated in FIG. 3, the IR pixels 11IR may be arranged in a checkered pattern, and three types of visible light pixels may be arranged in the remaining portions. FIG. 3 is a plan view illustrating another example of the pixel array unit 10 according to an embodiment of the present disclosure.

FIG. 4 is a cross-sectional view schematically illustrating a structure of the pixel array unit 10 according to an embodiment of the present disclosure, and is a view corresponding to a cross-sectional view taken along line A-A of FIG. 2.

As illustrated in FIG. 4, the pixel array unit 10 according to the embodiment includes a semiconductor layer 20, a wiring layer 30, and an optical layer 40. Then, in the pixel array unit 10, the optical layer 40, the semiconductor layer 20, and the wiring layer 30 are laminated in this order from the side on which light L from the outside is incident (hereinafter, also referred to as a light incident side).

The semiconductor layer 20 includes a semiconductor region 21 of a first conductivity type (for example, P-type) and a semiconductor region 22 of a second conductivity type (for example, N-type). Then, in the semiconductor region 21 of the first conductivity type, the semiconductor region 22 of the second conductivity type is formed in units of pixels, forming the photodiode PD by PN junction. The photodiode PD is an example of a photoelectric conversion unit.

In addition, the above-described separation region 23 is provided in the semiconductor layer 20. The separation region 23 separates the photodiodes PD of the unit pixels 11 adjacent to each other. The separation region 23 is formed by, for example, a trench provided by digging the semiconductor region 22. In addition, in the separation region 23, a light shielding wall 24 and a metal oxide film 25 are provided.

The light shielding wall 24 is a wall-shaped film that is provided along the separation region 23 in plan view and shields light obliquely incident from the adjacent unit pixel 11. By providing such a light shielding wall 24, it is possible to suppress incidence of light transmitted through the adjacent unit pixels 11, and thus, it is possible to suppress occurrence of color mixing.

The light shielding wall 24 is made of a material having a light shielding property, such as various metals (tungsten, aluminum, silver, copper and alloys of these) or a black organic film. In addition, in the embodiment, the light shielding wall 24 does not penetrate the semiconductor layer 20, and extends from the surface on the light incident side of the semiconductor layer 20 to the middle of the semiconductor layer 20.

The metal oxide film 25 is provided to cover the light shielding wall 24 in the separation region 23. In addition, the metal oxide film 25 is provided to cover the surface on the light incident side of the semiconductor region 21. The metal oxide film 25 is made of, for example, a material having a fixed charge (for example, hafnium oxide, tantalum oxide, aluminum oxide, zirconium oxide, and the like).

In the embodiment, an antireflection film, an insulating film, and the like may be separately provided between the metal oxide film 25 and the light shielding wall 24.

The wiring layer 30 is arranged on the surface on the opposite side of the light incident side of the semiconductor layer 20. The wiring layer 30 is configured by forming a plurality of layers of wiring 32 and a plurality of pixel transistors 33 in an interlayer insulating film 31. The plurality of pixel transistors 33 reads out charges accumulated in the photodiode PD, and the like.

In addition, the wiring layer 30 according to the embodiment further includes a metal layer 34 made of a metal containing tungsten as a main component. The metal layer 34 is provided on the light incident side of the plurality of layers of wiring 32 in each unit pixel 11. Details of the metal layer 34 will be described later.

The optical layer 40 is arranged on the surface on the light incident side of the semiconductor layer 20. The optical layer 40 includes an IR cut filter 41, a planarizing film 42, a color filter 43, and an on-chip lens (OCL) 44.

The IR cut filter 41 is formed of an organic material to which a near-infrared absorbing dye is added as an organic coloring material. The IR cut filter 41 is arranged on the surface on the light incident side of the semiconductor layer 20 in the visible light pixel (R pixel 11R, G pixel 11G, and B pixel 11B), and is not arranged on the surface on the light incident side of the semiconductor layer 20 in the IR pixel 11IR. Details of the IR cut filter 41 will be described later.

The planarizing film 42 is provided to planarize the surface on which the color filter 43 and the OCL 44 are formed and to avoid unevenness occurring in the rotational coating process when the color filter 43 and the OCL 44 are formed.

The planarizing film 42 is formed of, for example, an organic material (for example, acrylic resin). Note that the planarizing film 42 is not limited to being formed of an organic material, and may be formed of silicon oxide, silicon nitride, and the like.

In addition, as described above, since the IR cut filter 41 is not provided in the IR pixel 11IR, the planarizing film 42 is in direct contact with the metal oxide film 25 of the semiconductor layer 20 in the IR pixel 11IR.

The color filter 43 is an optical filter that transmits light of a predetermined wavelength among the light L collected by the OCL 44. The color filters 43 are arranged on a surface on the light incident side of the planarizing film 42 in the visible light pixel (R pixel 11R, G pixel 11G, and B pixel 11B).

The color filter 43 includes, for example, a color filter 43R that transmits red light, a color filter 43G that transmits green light, and a color filter 43B that transmits blue light.

In the embodiment, the color filter 43R is provided in the R pixel 11R, the color filter 43G is provided in the G pixel 11G, and the color filter 43B is provided in the B pixel 11B. In addition, in the embodiment, the color filter 43 is not arranged in the IR pixel 11IR.

The OCL 44 is a lens that is provided for each unit pixel 11 and collects the light L on the photodiode PD of each unit pixel 11. The OCL 44 is made of, for example, an acrylic resin and the like. In addition, as described above, since the color filter 43 is not provided in the IR pixel 11 IR, the OCL 44 is in direct contact with the planarizing film 42 in the IR pixel 11IR.

In addition, in the interface between the IR cut filter 41 or the planarizing film 42 and the semiconductor layer 20, a light shielding wall 45 is provided at a position corresponding to the separation region 23. The light shielding wall 45 is a wall-shaped film that shields light obliquely incident from the adjacent unit pixel 11, and is provided to be connected to the light shielding wall 24.

By providing such a light shielding wall 45, it is possible to suppress incidence of light transmitted through the IR cut filter 41 and the planarizing film 42 of the adjacent unit pixels 11, and thus, it is possible to suppress occurrence of color mixing. The light shielding wall 45 is made of, for example, aluminum, tungsten, and the like.

Here, in the embodiment, the occurrence of color mixing can be suppressed by arranging the metal layer 34 made of metal containing tungsten as a main component in each unit pixel 11. The reason for this will be described below.

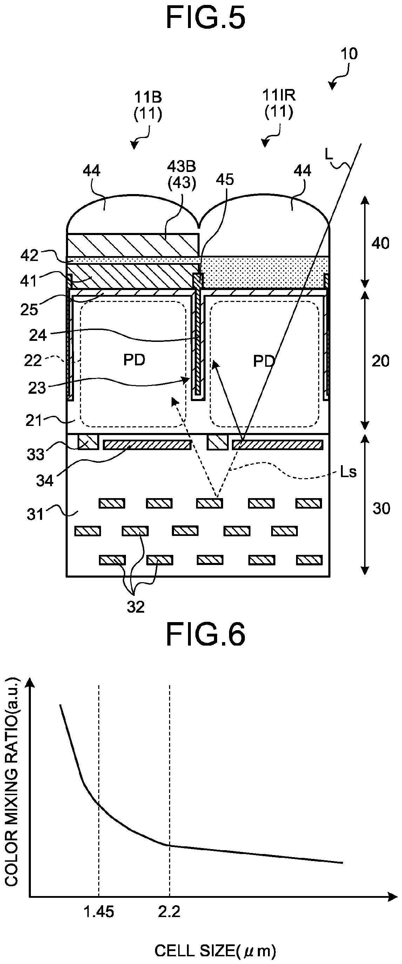

FIG. 5 is a view for explaining a function of the metal layer 34 according to an embodiment of the present disclosure. If the metal layer 34 is not provided in each unit pixel 11, out of the light L incident on the IR pixel 11IR, the light L that has passed through the semiconductor layer 20 is reflected by the wiring 32 as stray light Ls and leaks into the adjacent unit pixel 11.

In particular, since infrared light has a longer wavelength than visible light and thus has a longer optical path length, a phenomenon that infrared light leaks into the adjacent unit pixel 11 as stray light Ls as described above is remarkably observed. In addition, since copper or a copper alloy used as the wiring 32 has a refractive index significantly different from that of silicon in the infrared region (refractive index n $\approx$ 0.3), the copper or the copper alloy diffusely reflects the stray light Ls that has leaked. As a result, the crosstalk characteristic of the pixel array unit 10 deteriorates.

However, in the embodiment, the metal layer 34 is provided to face the photodiode PD of the visible light pixel and the IR pixel 11IR on the opposite side of the light incident side. As a result, as illustrated in FIG. 5, the light L that has passed through the photodiode PD of the IR pixel 11IR can be suppressed from reaching the wiring 32 of the wiring layer 30.

This is because tungsten constituting the metal layer 34 has a refractive index close to that of silicon in the infrared region (refractive index n $\approx$ 3.5), and thus the light L can be reflected by the photodiode PD of the IR pixel 11IR without being diffusely reflected.

Therefore, according to the embodiment, since it is possible to suppress the stray light Ls reflected by the wiring 32 from leaking into the adjacent unit pixel 11, it is possible to suppress the occurrence of color mixing in the pixel array unit 10 in which the visible light pixel and the IR pixel 11IR are arranged side by side.

In addition, by using tungsten having a high melting point as the main component of the metal layer 34, the metal layer 34 is not greatly altered even in the manufacturing process of the pixel array unit 10 after the metal layer 34 is formed, in a manner that the manufacturing process of the metal layer 34 can be easily incorporated.

In the embodiment, the case where the metal layer 34 is made of a metal containing tungsten as a main component has been described, but the metal layer 34 may not necessarily contain tungsten as a main component. For example, in the embodiment, a material having a refractive index of 1 or more in the infrared region may be used as the metal layer 34.

Also by this, the light L can be reflected by the photodiode PD of the IR pixel 11IR without being diffusely reflected, in a manner that the occurrence of color mixing caused by the IR pixel 11IR can be suppressed.

In addition, in the embodiment, a material having an electric resistance of 20 ($\mu\Omega$m) or less may be used as the metal layer 34. Also by this, the light L can be reflected by the photodiode PD of the IR pixel 11IR without being diffusely reflected, in a manner that the occurrence of color mixing caused by the IR pixel 11IR can be suppressed.

In addition, in the embodiment, the metal layer 34 is preferably provided on the light incident side of the plurality of layers of wiring 32 in the wiring layer 30. As a result, the light L that has passed through the photodiode PD of the IR pixel 11IR can further be suppressed from reaching the wiring 32 of the wiring layer 30.

Therefore, according to the embodiment, it is possible to further suppress the occurrence of color mixing in the pixel array unit 10 in which the visible light pixel and the IR pixel 11IR are arranged side by side.

In addition, in the embodiment, the metal layer 34 is preferably connected to the ground potential via a wiring (not illustrated). As a result, in the manufacturing process of the pixel array unit 10, the occurrence of arcing caused by the metal layer 34 can be suppressed, in a manner that the pixel array unit 10 can be stably manufactured.

In addition, by connecting the metal layer 34 to the ground potential, the occurrence of parasitic capacitance caused by the metal layer 34 can be suppressed, and thus, it is possible to suppress variations in sensitivity in each unit pixel 11.

In the present disclosure, the metal layer 34 is not limited to the case of being connected to the ground potential, and the metal layer 34 may function as a part of the wiring 32 of the wiring layer 30. As a result, since the wiring 32 can be partially omitted, the manufacturing cost of the pixel array unit 10 can be reduced.

In addition, in the embodiment, a barrier metal layer having a high barrier property may be provided on at least one main surface (that is, the main surface on the light incident surface side or the main surface on the opposite side of the light incident surface) of the metal layer 34. The barrier metal layer is made of, for example, a metal such as tantalum, titanium, ruthenium, cobalt, and manganese.

As a result, the adhesion force between the metal layer 34 and the interlayer insulating film 31 can be increased, in a manner that the reliability of the pixel array unit 10 can be improved.

In addition, in the embodiment, the distance in the thickness direction between the lower end of the light shielding wall 24 and the surface of the metal layer 34 is preferably in the range of 500 (nm) to 1000 (nm). If the distance between the lower end of the light shielding wall 24 and the surface of the metal layer 34 is smaller than 500 (nm), it is necessary to form the light shielding wall 24 deeper, which increases the manufacturing cost of the pixel array unit 10.

On the other hand, in a case where the distance between the lower end of the light shielding wall 24 and the surface of the metal layer 34 is larger than 1000 (nm), the gap with the adjacent unit pixel 11 becomes large, in a manner that the effect of suppressing color mixture is deteriorated.

However, in the embodiment, since the distance between the lower end of the light shielding wall 24 and the surface of the metal layer 34 is in the range of 500 (nm) to 1000 (nm), the manufacturing cost of the pixel array unit 10 can be reduced, and the occurrence of color mixing can be suppressed.

In addition, in the embodiment, the distance in the thickness direction between the lower surface (that is, the interface with the wiring layer 30) of the semiconductor layer 20 and the surface of the metal layer 34 is preferably in the range of 50 (nm) to 200 (nm). If the distance between the lower surface of the semiconductor layer 20 and the surface of the metal layer 34 is smaller than 50 (nm), the insulation of the semiconductor layer 20 may be deteriorated.

On the other hand, in a case where the distance between the lower surface of the semiconductor layer 20 and the surface of the metal layer 34 is larger than 200 (nm), the gap with the adjacent unit pixel 11 becomes large, in a manner that the effect of suppressing color mixture is deteriorated.

However, in the embodiment, since the distance between the lower surface of the semiconductor layer 20 and the surface of the metal layer 34 is in the range of 50 (nm) to 200 (nm), the reliability of the pixel array unit 10 can be secured, and the occurrence of color mixing can be suppressed.

In addition, in the embodiment, the thickness of the metal layer 34 is preferably in the range of 50 (nm) to 200 (nm). If the thickness of the metal layer 34 is smaller than 50 (nm), it is difficult to effectively reflect the light L, in a manner that the effect of suppressing color mixing is reduced.

On the other hand, in a case where the thickness of the metal layer 34 is larger than 200 (nm), the wiring layer 30 becomes thick, which increases the manufacturing cost of the pixel array unit 10.

However, in the embodiment, since the thickness of the metal layer 34 is in the range of 50 (nm) to 200 (nm), the manufacturing cost of the pixel array unit 10 can be reduced, and the occurrence of color mixing can be suppressed.

Here, the definition of the pixel according to the present disclosure will be described. In the case of a pixel array unit in which pixels having a square shape in plan view are arranged in a matrix, there are a pixel array unit in which an on-chip lens is provided for each pixel, a pixel array unit in which one on-chip lens is provided for two adjacent pixels, a pixel array unit in which one on-chip lens is provided for four pixels adjacent in the matrix direction, and a pixel array unit in which one color filter is provided for four pixels adjacent in the matrix direction. For these pixel array units, one pixel is defined as one pixel, and a length of one side of one pixel in plan view is defined as a cell size.

In addition, for example, in a case where a pixel having a square shape in plan view is separated into two divided pixels having the same area and a rectangular shape in plan view, a pixel having a square shape in plan view in which the two divided pixels are combined is defined as one pixel, and a length of one side of one pixel in plan view is defined as a cell size.

In addition, depending on the solid-state imaging element 1, for example, there is a pixel array unit in which two types of pixels having different sizes are alternately two-dimensionally arranged. In this case, for each of the large pixel and the small pixel, a pixel having the shortest distance between opposing sides is defined as a fine pixel.

Here, in the pixel array unit 10 according to the embodiment, the cell size is preferably 2.2 ($\mu$m) or less, and more preferably 1.45 ($\mu$m) or less. FIG. 6 is a view illustrating a relationship between a cell size and a color mixing ratio in a pixel array unit of a reference example.

As illustrated in FIG. 6, in the pixel array unit of the reference example, the color mixing ratio rapidly increases when the cell size becomes 2.2 ($\mu$m) or less. That is, in the pixel array unit of the reference example, when the cell size is miniaturized in a range of 2.2 ($\mu$m) or less, color mixing rapidly increases, and thus, it is very difficult to miniaturize the pixel array unit.

However, in the pixel array unit 10 according to the embodiment, since the occurrence of color mixing can be suppressed as described above, it is possible to acquire an image that does not raise a problem in practical use even if the cell size is miniaturized to 2.2 ($\mu$m) or less.

In addition, as illustrated in FIG. 6, in the pixel array unit of the reference example, the color mixing ratio further rapidly increases when the cell size becomes 1.45 ($\mu$m) or less. That is, in the pixel array unit of the reference example, when the cell size is miniaturized in a range of 1.45 ($\mu$m) or less, color mixing further rapidly increases, and thus, it is more difficult to miniaturize the pixel array unit.

However, in the pixel array unit 10 according to the embodiment, since the occurrence of color mixing can be suppressed as described above, it is possible to acquire an image that does not raise a problem in practical use even if the cell size is miniaturized to 1.45 ($\mu$m) or less.

<First modification>

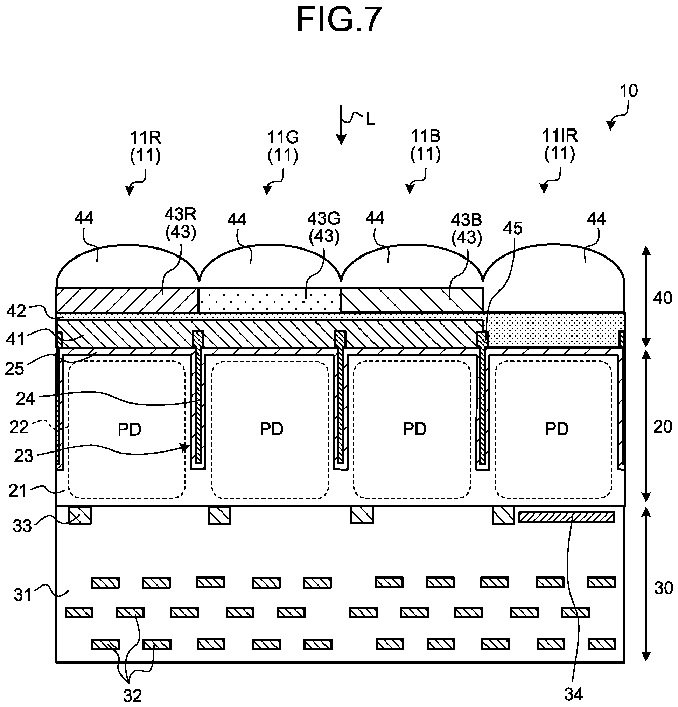

Next, various modifications of the pixel array unit 10 according to the embodiment will be described. FIG. 7 is a cross-sectional view schematically illustrating a structure of a pixel array unit 10 according to a first modification of the embodiment of the present disclosure.

In the first modification illustrated in FIG. 7, the arrangement of the metal layer 34 is different from that of the embodiment. Specifically, in the example of FIG. 7, the metal layer 34 is not provided in the visible light pixel (R pixel 11R, G pixel 11G, and B pixel 11B), and is provided only in the IR pixel 11IR.

Also by this, the light L that has passed through the photodiode PD of the IR pixel 11IR can be suppressed from reaching the wiring 32 of the wiring layer 30. Therefore, according to the first modification, since it is possible to suppress the stray light Ls (see FIG. 5) reflected by the wiring 32 from leaking into the adjacent unit pixel 11, it is possible to suppress the occurrence of color mixing.

<Second modification>

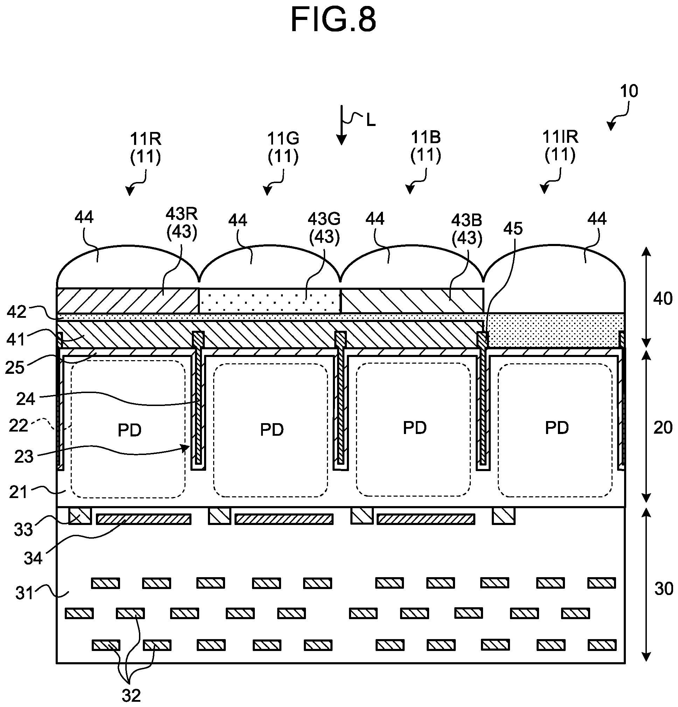

FIG. 8 is a cross-sectional view schematically illustrating a structure of a pixel array unit 10 according to a second modification of the embodiment of the present disclosure. In the second modification illustrated in FIG. 8, the arrangement of the metal layer 34 is different from that of the embodiment and the first modification.

Specifically, in the example of FIG. 8, the metal layer 34 is not provided in the IR pixel 11IR, but is provided only in the visible light pixel (R pixel 11R, G pixel 11G, and B pixel 11B). That is, in the second modification, the metal layer 34 is provided to face the photodiode PD of the visible light pixel on the opposite side of the light incident side.

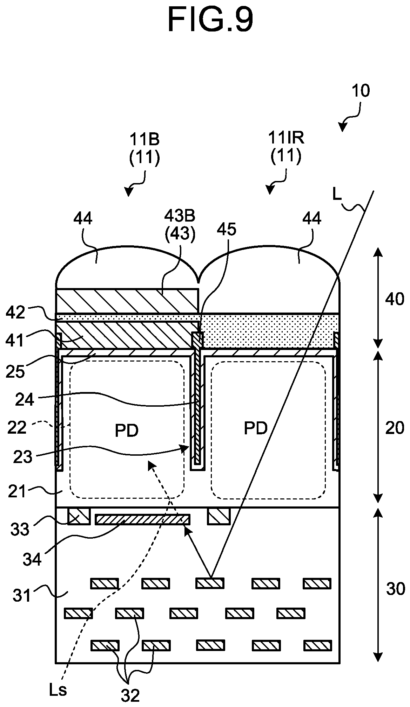

As a result, as illustrated in FIG. 9, the light L that has passed through the photodiode PD of the IR pixel 11IR and has been reflected by the wiring 32 can be suppressed from being incident on the photodiode PD of the visible light pixel as stray light Ls.

Therefore, according to the second modification, the occurrence of color mixing can be suppressed. FIG. 9 is a view for explaining a function of a metal layer 34 according to the second modification of the embodiment of the present disclosure.

<Third modification>

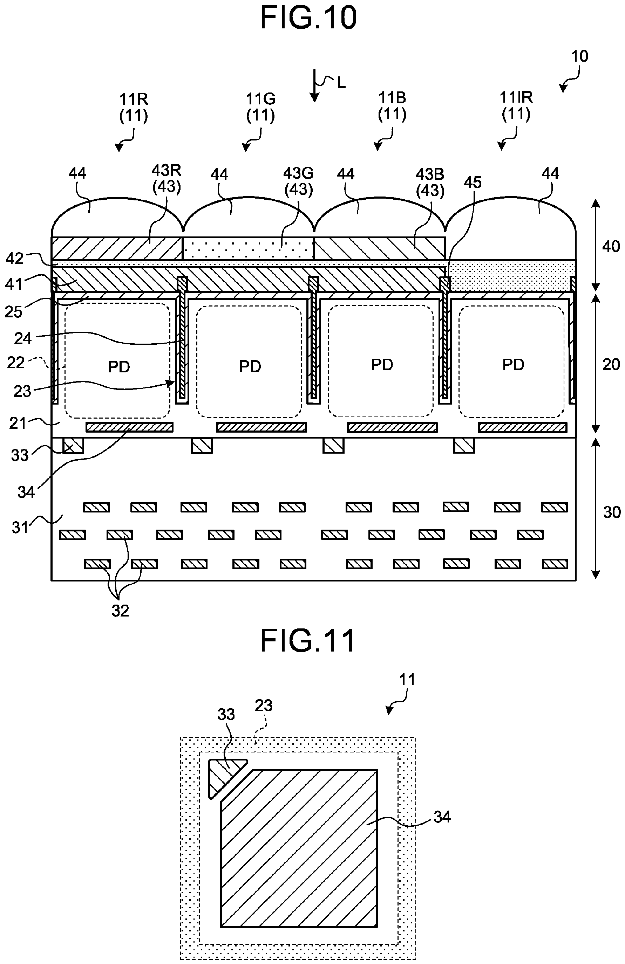

In the embodiment and various modifications described so far, an example in which the metal layer 34 is provided in the wiring layer 30 has been described, but the metal layer 34 is not limited to the case of being provided in the wiring layer 30. FIG. 10 is a cross-sectional view schematically illustrating a structure of a pixel array unit 10 according to a third modification of the embodiment of the present disclosure.

In the third modification illustrated in FIG. 10, the metal layer 34 is provided inside the semiconductor layer 20 to face the photodiode PD of the visible light pixel and the IR pixel 11IR on the opposite side of the light incident side.

Also by this, the light L that has passed through the photodiode PD of the IR pixel 11IR can be suppressed from reaching the wiring 32 of the wiring layer 30. Therefore, according to the third modification, since it is possible to suppress the stray light Ls (see FIG. 5) reflected by the wiring 32 from leaking into the adjacent unit pixel 11, it is possible to suppress the occurrence of color mixing.

<Planar structure of metal layer>

FIG. 11 is a plan view illustrating an example of a configuration and arrangement of the metal layer 34 according to an embodiment of the present disclosure. As illustrated in FIG. 11, in one unit pixel 11, the metal layer 34 is preferably arranged as large as possible within a range not interfering with other components (for example, the pixel transistor 33).

That is, as illustrated in FIG. 11, the metal layer 34 according to the embodiment may be arranged not to overlap the pixel transistor 33 in plan view. As a result, since the metal layer 34 can be thinned, the entire wiring layer 30 can be thinned, in a manner that the manufacturing cost of the pixel array unit 10 can be reduced.

In addition, in the embodiment, since it is possible to suppress the occurrence of parasitic capacitance due to the overlapping of the metal layer 34 and the pixel transistor 33, it is possible to suppress variations in sensitivity in each unit pixel 11.

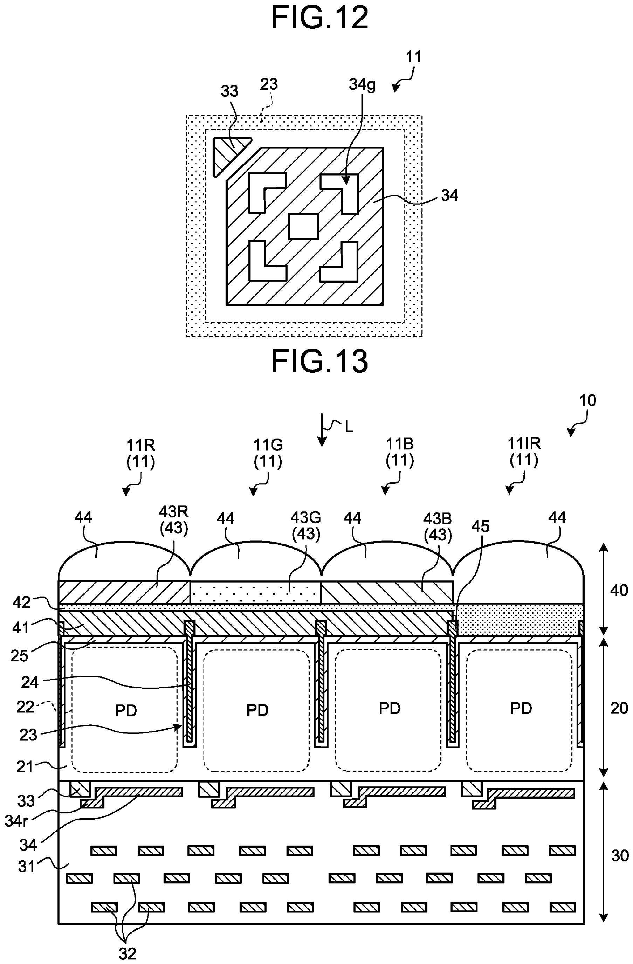

FIG. 12 is a plan view illustrating another example of the configuration and arrangement of the metal layer 34 according to an embodiment of the present disclosure. As illustrated in FIG. 12, the metal layer 34 may have a gap 34g in plan view. As a result, optical interference due to variations in film thickness between the semiconductor layer 20 and the metal layer 34 can be suppressed.

For example, in a case where the wavelength of light is λ1 (nm) and the refractive index of the interlayer insulating film 31 is n1, the width of the gap 34g provided in the metal layer 34 is preferably a width of X or more obtained by the following formula (1).

$$X = \lambda1/n1/2 \qquad\qquad (1)$$

For example, when λ1 = 850 (nm) and n1 = 1.5, a width X of the gap 34g provided in the metal layer 34 may be set to 850/(1.5)/2 ≈ 283 (nm) or more.

<Fourth modification>

FIG. 13 is a cross-sectional view schematically illustrating a structure of a pixel array unit 10 according to a fourth modification of the embodiment of the present disclosure. As illustrated in FIG. 13, the metal layer 34 may have a raised portion 34r, and the raised portion 34r may be arranged to ride on the opposite side of the light incident side of the pixel transistor 33.

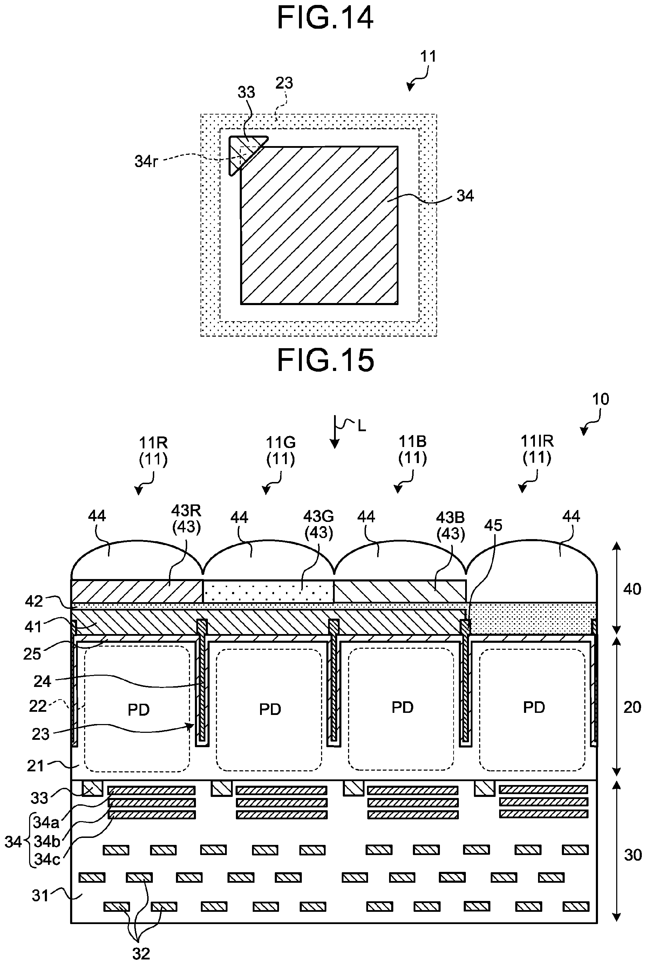

That is, as illustrated in FIG. 14, the metal layer 34 of the fourth modification may be arranged to overlap the pixel transistor 33 in plan view. FIG. 14 is a plan view illustrating an example of a configuration and arrangement of a metal layer 34 according to the fourth modification of the embodiment of the present disclosure.

As a result, since the area of the metal layer 34 in one unit pixel 11 can be maximized, it is possible to further suppress leakage of the light L having passed through the photodiode PD of the IR pixel 11IR into the adjacent unit pixel 11 as the stray light Ls (see FIG. 5). Therefore, according to the fourth modification, the occurrence of color mixing can further be suppressed.

In addition, in the fourth modification, the light L before reaching the raised portion 34r of the metal layer 34 can be absorbed by the polysilicon of the pixel transistor 33. Therefore, according to the fourth modification, since the amount of the light L itself reaching the metal layer 34 can be reduced, it is possible to further suppress the stray light Ls from leaking into the adjacent unit pixel 11.

In addition, in the fourth modification, as illustrated in FIG. 14, it is preferable that the direction of the side of the portion of the pixel transistor 33 that rides on the raised portion 34r is not parallel to the direction of the side of the raised portion 34r.

<Fifth modification>

FIG. 15 is a cross-sectional view schematically illustrating a structure of a pixel array unit 10 according to a fifth modification of the embodiment of the present disclosure. As illustrated in FIG. 15, the metal layer 34 may be a multilayer. The metal layer 34 of the fifth modification has, for example, a three-layer structure including a metal layer 34a, a metal layer 34b, and a metal layer 34c in order from the light incident side.

In the metal layer 34 of the fifth modification, all the light L is not received by the first metal layer 34a but transmitted through the lower metal layers 34b and 34c, in a manner that the light L can be absorbed, interfered, and diffracted by the lower metal layers 34b and 34c.

As a result, it is possible to further suppress leakage of the light L having passed through the photodiode PD of the IR pixel 11IR into the adjacent unit pixel 11 as the stray light Ls (see FIG. 5). Therefore, according to the fifth modification, the occurrence of color mixing can further be suppressed.

In the metal layer 34 of the fifth modification, the metal layer 34a, the metal layer 34b, and the metal layer 34c may be all solid films (films without the gap 34g (see FIG. 12)) or films with the gap 34g.

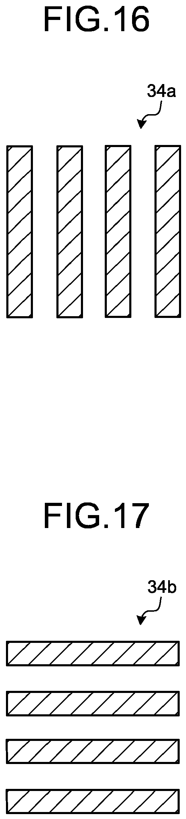

For example, as illustrated in FIGS. 16 to 18, the first metal layer 34a may have a vertical stripe shape, the second metal layer 34b may have a horizontal stripe shape, and the third metal layer 34c may have a dot shape complementing them. FIGS. 16 to 18 are plan views illustrating an example of metal layers 34a to 34c according to the fifth modification of the embodiment of the present disclosure.

In this case, the width of the gap 34g provided in the metal layer 34a, the metal layer 34b, and the metal layer 34c is preferably equal to or more than the width X obtained by the above-described formula (1).

Note that the configurations of the metal layers 34a, 34b, and 34c are not limited to the examples of FIGS. 16 to 18. For example, only the third metal layer 34c may be a solid film. In addition, the first metal layer 34a may have a horizontal stripe shape, the second metal layer 34b may have a vertical stripe shape, and the third metal layer 34c may have a dot shape (or a solid film) complementing them.

In addition, the first metal layer 34a may have an oblique stripe shape, the second metal layer 34b may have an oblique stripe shape in a direction orthogonal to the metal layer 34a, and the third metal layer 34c may have a dot shape (or a solid film) complementing them.

<Sixth modification>

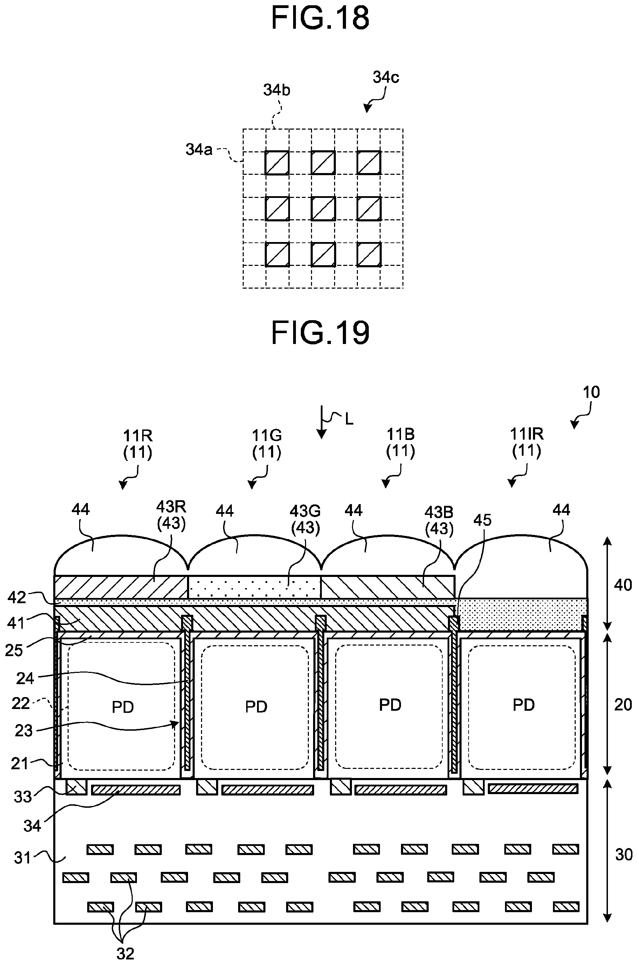

FIG. 19 is a cross-sectional view schematically illustrating a structure of a pixel array unit 10 according to a sixth modification of the embodiment of the present disclosure. As illustrated in FIG. 19, in the pixel array unit 10 of the sixth modification, the light shielding wall 24 of the separation region 23 is provided to penetrate the semiconductor layer 20.

As a result, since it is possible to further suppress the light L reflected by the metal layer 34 from leaking into the adjacent unit pixel 11, it is possible to further suppress the occurrence of color mixing.

<Seventh modification>

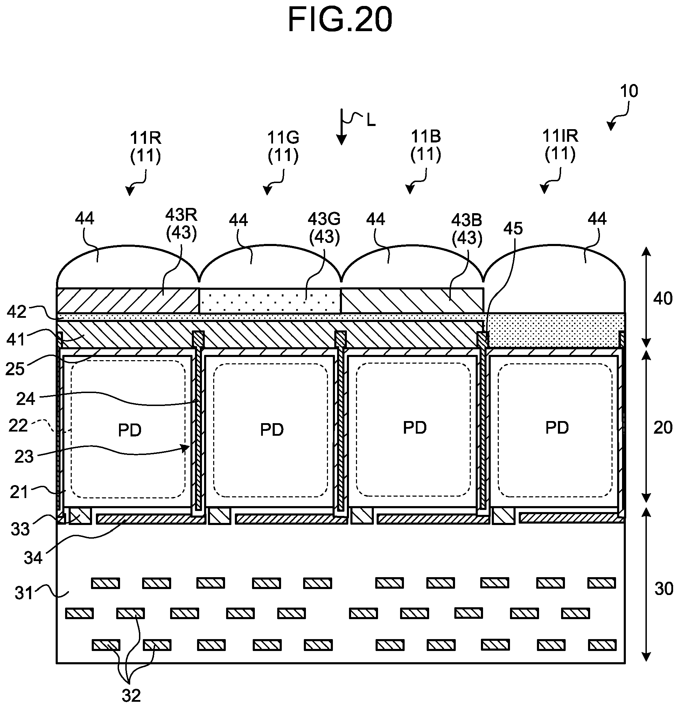

FIG. 20 is a cross-sectional view schematically illustrating a structure of a pixel array unit 10 according to a seventh modification of the embodiment of the present disclosure. As illustrated in FIG. 20, in the pixel array unit 10 of the seventh modification, the light shielding wall 24 of the separation region 23 is provided to penetrate the semiconductor layer 20 and reach the metal layer 34 of the wiring layer 30.

As a result, since it is possible to further suppress the light L reflected by the metal layer 34 from leaking into the adjacent unit pixel 11, it is possible to further suppress the occurrence of color mixing.

In the example of FIG. 20, the light shielding wall 24 and the metal layer 34 are in contact with each other with the metal oxide film 25 interposed between, but the light shielding wall 24 and the metal layer 34 may be in direct contact with each other without the metal oxide film 25 interposed between.

As a result, for example, in a case where the light shielding wall 24 of the separation region 23 is fixed at a predetermined potential, the metal layer 34 is also fixed at the predetermined potential, so that it is possible to suppress the metal layer 34 from being in a floating state. Therefore, according to the seventh modification, it is possible to suppress the occurrence of shading in which the sensitivity characteristic in the peripheral region of the imaging region is deteriorated.

<Eighth modification>

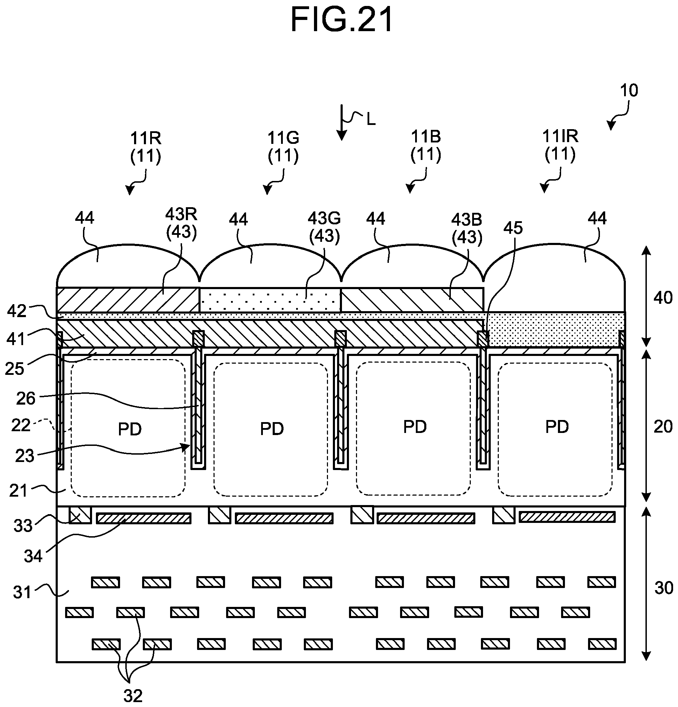

FIG. 21 is a cross-sectional view schematically illustrating a structure of a pixel array unit 10 according to an eighth modification of the embodiment of the present disclosure. As illustrated in FIG. 21, in the pixel array unit 10 of the eighth modification, instead of the light shielding wall 24 made of a material having a light shielding property, a transparent wall 26 made of a material having high transparency is provided in the separation region 23.

Also by this, since the metal layer 34 containing tungsten as a main component can reflect the light L to the photodiode PD of the IR pixel 11IR without diffusely reflecting the light L, occurrence of color mixture can be sufficiently suppressed.

The transparent wall 26 of the eighth modification is made of, for example, an inorganic material such as silicon oxide, silicon oxynitride, or silicon nitride, a silica-based organic material, and the like.

<Ninth modification>

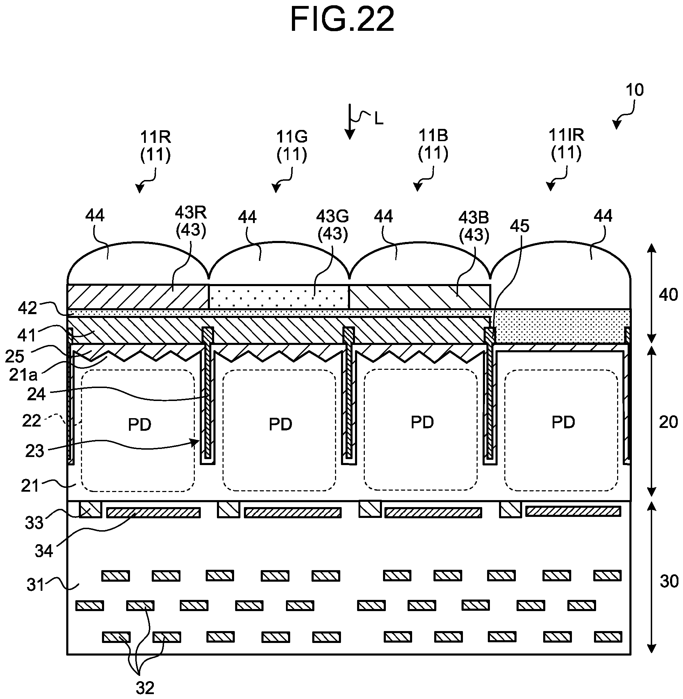

FIG. 22 is a cross-sectional view schematically illustrating a structure of a pixel array unit 10 according to a ninth modification of the embodiment of the present disclosure. As illustrated in FIG. 22, in the pixel array unit 10 of the ninth modification, a convex portion 21a is provided on a surface on the light incident side in the semiconductor region 21 of the visible light pixel.

In other words, by providing the concave portion on the surface on the light incident side in the semiconductor region 21, the convex portion is provided on the surface on the light incident side in the remaining semiconductor region. That is, in the ninth modification, the visible light pixel has a so-called moth-eye structure. The shape of the moth-eye structure refers to, for example, a shape of a concave portion formed by digging a surface on the light incident side in the semiconductor region 21 in an inverse pyramid shape.

With such a moth-eye structure, the light L incident on the visible light pixel can be confined in the photodiode PD of the incident visible light pixel to increase the optical path length, in a manner that the sensitivity of the visible light pixel can be improved.

Note that, in the example of FIG. 22, the moth-eye structure is formed in the visible light pixel, but the moth-eye structure may be formed in the IR pixel 11IR.

This also makes it possible to increase the optical path length by confining the light L incident on the IR pixel 11IR in the photodiode PD of the incident IR pixel 11IR, in a manner that the sensitivity of the IR pixel 11IR can be improved.

On the other hand, since at least one of the visible light pixel and the IR pixel 11IR has the moth-eye structure, the direction of the light L becomes oblique, in a manner that the occurrence of color mixing may increase.

However, in the pixel array unit 10 according to the ninth modification, since the occurrence of color mixing can be suppressed as described above, even if at least one of the visible light pixel and the IR pixel 11IR has the moth-eye structure, it is possible to acquire an image having no problem in practical use. That is, according to the ninth modification, both improvement of sensitivity and suppression of color mixing can be achieved.

<10th modification>

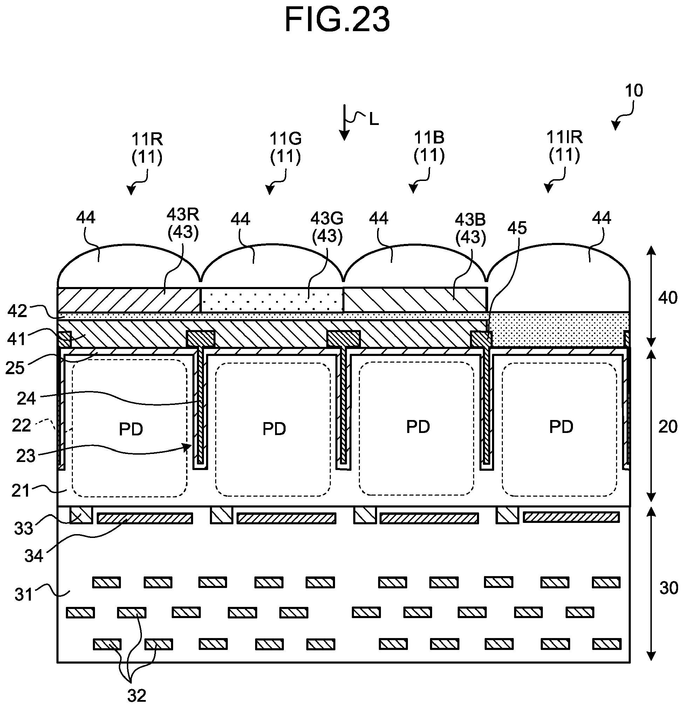

FIG. 23 is a cross-sectional view schematically illustrating a structure of a pixel array unit 10 according to a 10th modification of the embodiment of the present disclosure. As illustrated in FIG. 23, in the pixel array unit 10 of the 10th modification, the width between the adjacent light shielding walls 45 in the visible light pixel is narrower than the width between the adjacent light shielding walls 45 in the IR pixel 11IR.
As a result, visible light having a high light collection rate at the OCL 44 can be sufficiently collected on the visible light pixel, and infrared light having a light collection rate lower than that of the visible light at the OCL 44 can be suppressed from being incident on the photodiode PD of the visible light pixel.
That is, in the 10th modification, since the influence of the infrared light incident on the visible light pixel can be reduced, the noise of the signal output from the photodiode PD of the visible light pixel can be reduced.
In addition, in the 10th modification, by widening the width between the adjacent light shielding walls 45 in the IR pixel 11IR, a larger amount of infrared light having a low light collection rate in the OCL 44 can be incident on the IR pixel 11IR. That is, in the 10th modification, the intensity of the signal output from the IR pixel 11IR can be increased.
Therefore, according to the 10th modification, the quality of the signal output from the pixel array unit 10 can be improved.

<11th modification>

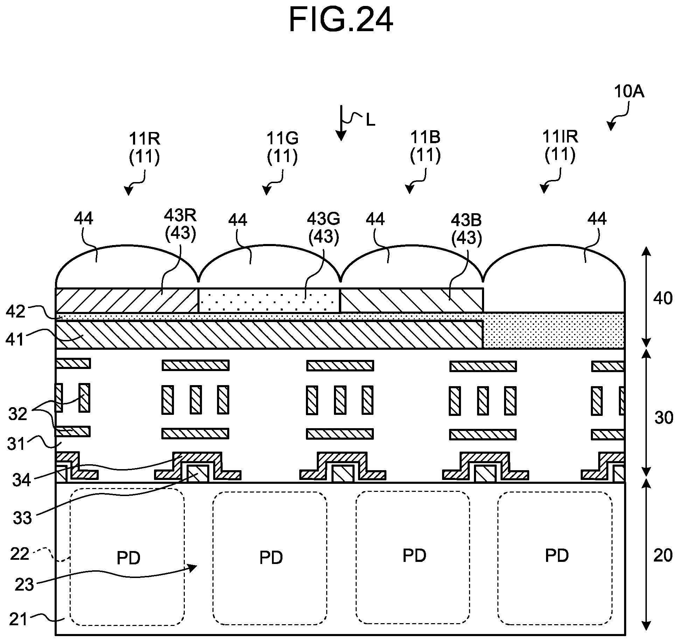

In the embodiment and various modifications described so far, an example in which the metal layer 34 is applied to the so-called back surface irradiation type pixel array unit 10 has been described, but the metal layer 34 of the present disclosure is not limited to such an example. FIG. 24 is a cross-sectional view schematically illustrating a structure of a pixel array unit 10A according to an 11th modification of the embodiment of the present disclosure.
As illustrated in FIG. 24, the pixel array unit 10A according to the 11th modification is a so-called front surface irradiation type pixel array unit, and the light L is incident the photodiode PD of each unit pixel 11 from the optical layer 40 via the wiring layer 30.
Then, in the 11th modification, in the wiring layer 30, the metal layer 34 is provided to cover the light incident side of the pixel transistor 33. This makes it possible to suppress infrared light from entering the photodiodes PD of the adjacent unit pixels 11.
Therefore, according to the 11th modification, it is possible to suppress the occurrence of color mixing in the front surface irradiation type pixel array unit 10A.

<12th modification>

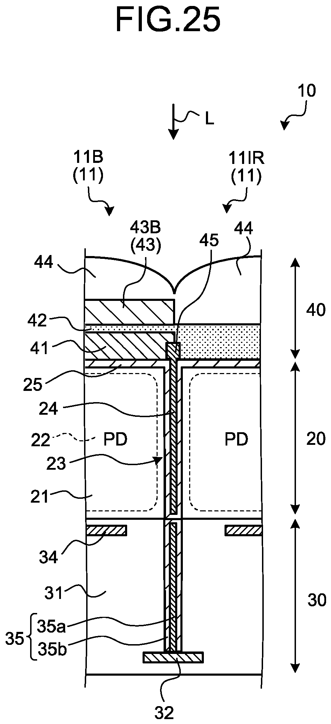

FIG. 25 is a cross-sectional view schematically illustrating a structure of a pixel array unit 10 according to a 12th modification of the embodiment of the present disclosure. As illustrated in FIG. 25, in the pixel array unit 10 of the 12th modification, the light shielding wall 24 of the separation region 23 is provided to penetrate the semiconductor layer 20.
Furthermore, in the 12th modification, a light shielding portion 35 penetrating from the tip portion of the light shielding wall 24 to the wiring 32 of the wiring layer 30 in the light incident direction is provided. The light shielding portion 35 includes a light shielding wall 35a and a metal oxide film 35b.
The light shielding wall 35a is a wall-shaped film that is provided along the separation region 23 in plan view and shields light incident from the adjacent unit pixel 11. The metal oxide film 35b is provided to cover the light shielding wall 35a in the light shielding portion 35. The light shielding wall 35a is made of the same material as the light shielding wall 24, and the metal oxide film 35b is made of the same material as the metal oxide film 25.
As illustrated in FIG. 25, by providing the light shielding portion 35 to be connected to the tip portion of the light shielding wall 24, it is possible to further suppress the stray light Ls (see FIG. 5) from leaking from the IR pixel 11IR to the adjacent unit pixel 11. Therefore, according to the 12th modification, the occurrence of color mixing can further be suppressed.

<13th modification>

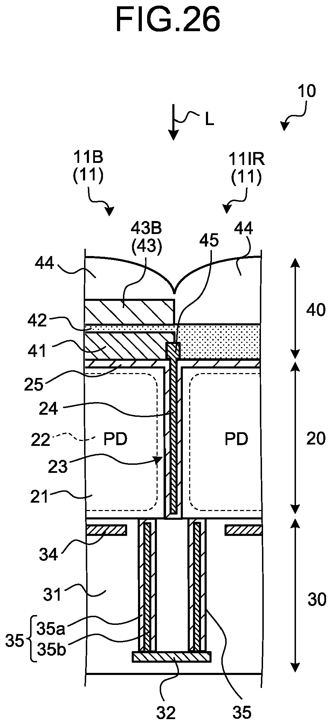

FIG. 26 is a cross-sectional view schematically illustrating a structure of a pixel array unit 10 according to a 13th modification of the embodiment of the present disclosure. As illustrated in FIG. 26, in the pixel array unit 10 of the 13th modification, the light shielding wall 24 of the separation region 23 is provided to penetrate the semiconductor layer 20.

Furthermore, in the 13th modification, a pair of light shielding portions 35 penetrating from the position adjacent to the tip portion of the light shielding wall 24 to the wiring 32 of the wiring layer 30 in the light incident direction is provided. That is, the pixel array unit 10 according to the 13th modification is configured in a manner that the tip portion of the light shielding wall 24 is surrounded by the pair of light shielding portions 35.

Also by this, it is possible further suppress the stray light Ls (see FIG. 5) from leaking from the IR pixel 11IR to the adjacent unit pixel 11. Therefore, according to the 13th modification, the occurrence of color mixing can further be suppressed. Note that, in the example of FIG. 26, the light shielding wall 24 may not necessarily be formed to penetrate the semiconductor layer 20.

<14th modification>

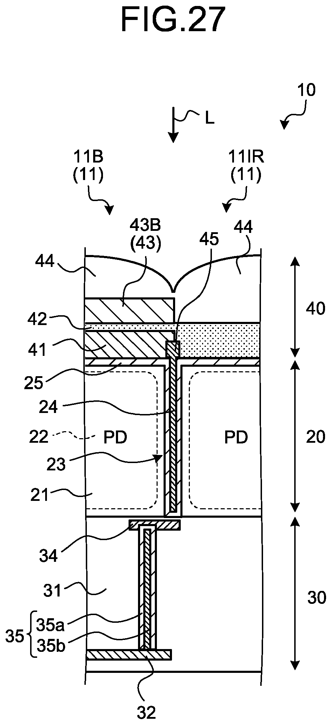

FIG. 27 is a cross-sectional view schematically illustrating a structure of a pixel array unit 10 according to a 14th modification of the embodiment of the present disclosure. As illustrated in FIG. 27, in the pixel array unit 10 of the 14th modification, the light shielding wall 24 of the separation region 23 is provided to penetrate the semiconductor layer 20 and reach the metal layer 34 of the wiring layer 30.

Furthermore, in the 14th modification, a pair of light shielding portions 35 penetrating from a position different from the light shielding wall 24 in the metal layer 34 to the wiring 32 of the wiring layer 30 in the light incident direction is provided. That is, in the 14th modification, the light shielding wall 24, the metal layer 34, and the light shielding portion 35 are configured as a portion having an integrated light shielding function.

Also by this, it is possible further suppress the stray light Ls (see FIG. 5) from leaking from the IR pixel 11IR to the adjacent unit pixel 11. Therefore, according to the 14th modification, the occurrence of color mixing can further be suppressed.

<Details of IR cut filter>

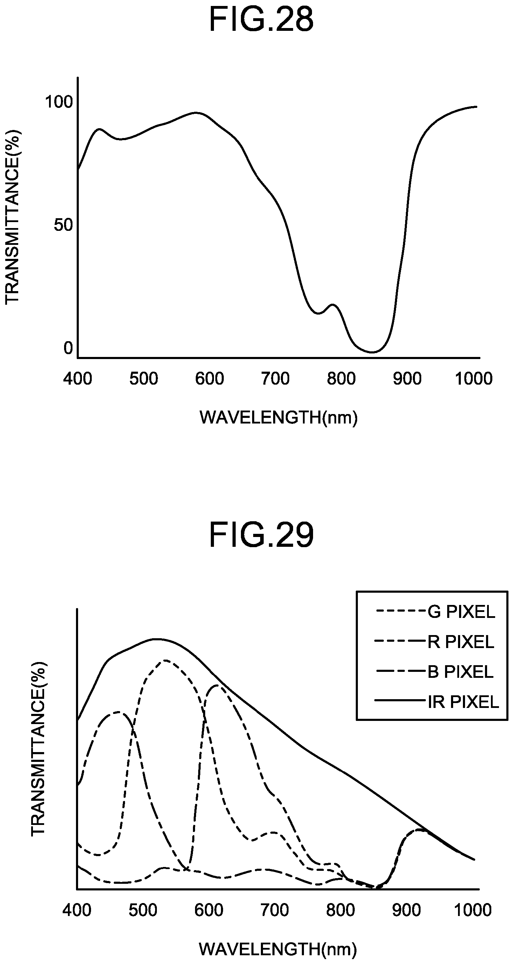

Next, details of the IR cut filter 41 provided in the visible light pixel will be described with reference to FIGS. 28 to 34 and FIG. 4 described above. FIG. 28 is a view illustrating an example of a spectral characteristic of an IR cut filter 41 according to an embodiment of the present disclosure.

As illustrated in FIG. 28, the IR cut filter 41 has a spectral characteristic in which transmittance is 30 (%) or less in a wavelength region of 700 (nm) or more, and particularly has an absorption maximum wavelength in a wavelength region near 850 (nm).

Then, as illustrated in FIG. 4, in the pixel array unit 10 according to the embodiment, the IR cut filter 41 is arranged on the surface on the light incident side of the semiconductor layer 20 in the visible light pixel, and is not arranged on the surface on the light incident side of the semiconductor layer 20 in the IR pixel 11IR.

In addition, in the pixel array unit 10 according to the embodiment, the color filter 43R that transmits red light is arranged in the R pixel 11R, and the color filter 43G that transmits green light is arranged in the G pixel 11G. Furthermore, in the pixel array unit 10 according to the embodiment, a color filter 43B that transmits blue light is arranged in the B pixel 11B.

With these filters, the spectral characteristic of the light incident on the photodiode PD of the R pixel 11R, the G pixel 11G, the B pixel 11B, and the IR pixel 11IR are as illustrated in a graph in FIG. 29. FIG. 29 is a view illustrating an example of a spectral characteristic of each unit pixel according to an embodiment of the present disclosure.

As illustrated in FIG. 29, in the pixel array unit 10 according to the embodiment, the spectral characteristic of the R pixel 11R, the G pixel 11G, and the B pixel 11B have low transmittance in the infrared light region of wavelengths of about 750 (nm) to 850 (nm).

That is, in the embodiment, by providing the IR cut filter 41 in the visible light pixel, since the influence of the infrared light incident on the visible light pixel can be reduced, the noise of the signal output from the photodiode PD of the visible light pixel can be reduced.

Furthermore, in the pixel array unit 10 according to the embodiment, since the IR cut filter 41 is not provided in the IR pixel 11IR, as illustrated in FIG. 29, the spectral characteristic of the IR pixel 11IR maintain high transmittance in the infrared light region.

That is, in the embodiment, since more infrared light can be incident on the IR pixel 11IR, the intensity of the signal output from the IR pixel 11IR can be increased.

As described above, in the pixel array unit 10 according to the embodiment, the quality of the signal output from the pixel array unit 10 can be improved by providing the IR cut filter 41 only in the visible light pixel.

In addition, in the embodiment, as illustrated in FIG. 4, since the IR cut filter 41 is not provided in the IR pixel 11IR, the planarizing film 42 is in direct contact with the metal oxide film 25 of the semiconductor layer 20 in the IR pixel 11IR.

As described above, by bringing the planarizing film 42 having a refractive index close to that of the metal oxide film 25 into direct contact with the metal oxide film 25, reflection and diffraction on the surface of the metal oxide film 25 can be suppressed.

Therefore, according to the embodiment, since the amount of light L that passes through the surface of the metal oxide film 25 and becomes incident on the photodiode PD of the IR pixel 11IR can be increased, the intensity of the signal output from the IR pixel 11IR can be further increased.

The IR cut filter 41 is formed of an organic material to which a near-infrared absorbing dye is added as an organic coloring material. Examples of the near-infrared absorbing dye include a pyrrolopyrrole dye, a copper compound, a cyanine dye, a phthalocyanine compound, an imonium compound, a thiol complex compound, and a transition metal oxide compound.

In addition, as the near-infrared absorbing dye used for the IR cut filter 41, for example, a squarylium dye, a naphthalocyanine dye, a quaterylene dye, a dithiol metal complex dye, a croconium compound, and the like are also used.

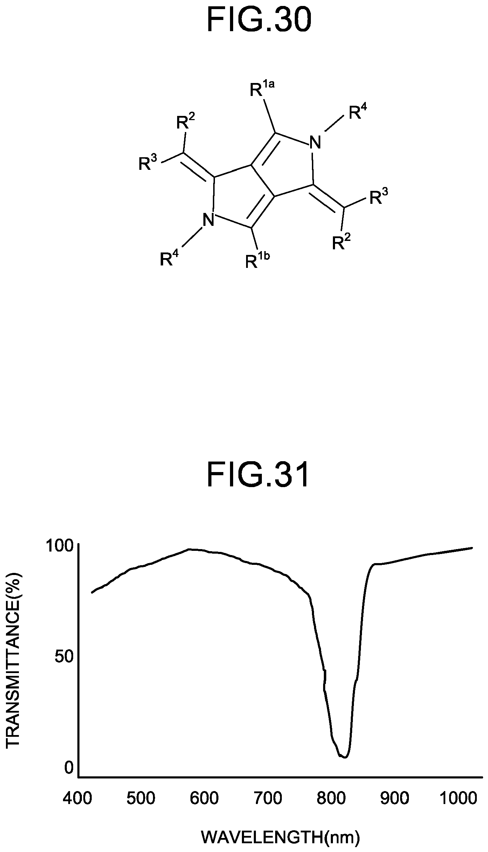

For the IR pixel 11IR according to the embodiment, the coloring material of the IR cut filter 41 is preferably a pyrrolopyrrole dye represented by the chemical formula of FIG. 30. FIG. 30 is a view illustrating an example of a coloring material of the IR cut filter 41 according to an embodiment of the present disclosure.

In FIG. 30, $R^{1a}$ and $R^{1b}$ each independently represent an alkyl group, an aryl group, or a heteroaryl group. $R^2$ and $R^3$ each independently represent a hydrogen atom or a substituent, and at least one of $R^2$ and $R^3$ is an electron-attracting group. $R^2$ and $R^3$ may be bonded to each other to form a ring.

$R^4$ represents a hydrogen atom, an alkyl group, an aryl group, a heteroaryl group, substituted boron, or a metal atom, and may be covalently bonded or coordinate-bonded to at least one of $R^{1a}$, $R^{1b}$, and $R^3$.

In the example of FIG. 28 described above, the spectral characteristic of the IR cut filter 41 has the absorption maximum wavelength in the wavelength region in the vicinity of 850 (nm), but the transmittance may be 30 (%) or less in the wavelength region of 700 (nm) or more.

FIGS. 31 to 34 are views illustrating another example of a spectral characteristic of the IR cut filter 41 according to an embodiment of the present disclosure. For example, as illustrated in FIG. 31, the spectral characteristic of the IR cut filter 41 may have a transmittance of 20 (%) in a wavelength region of 800 (nm) or more.

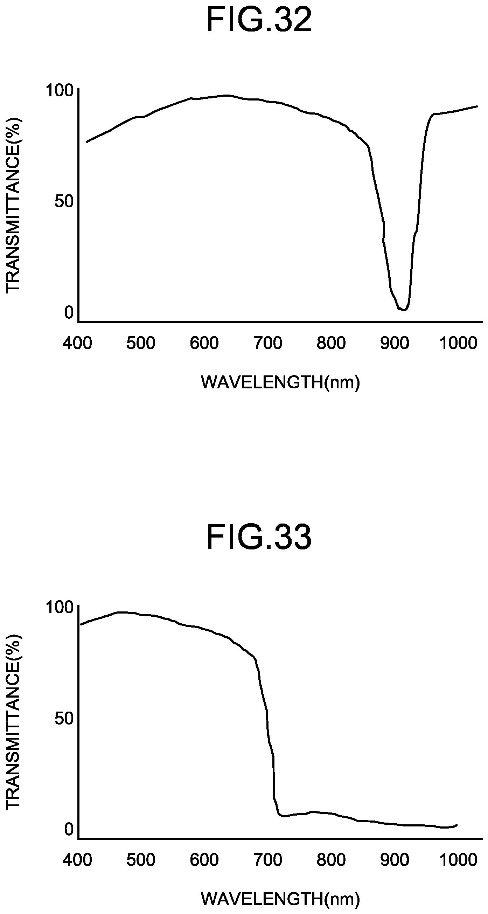

In addition, as illustrated in FIG. 32, the spectral characteristic of the IR cut filter 41 may have an absorption maximum wavelength in a wavelength region in the vicinity of 950 (nm). In addition, as illustrated in FIG. 33, the spectral characteristic of the IR cut filter 41 may have a transmittance of 20 (%) or less in the entire wavelength region of 750 (nm) or more.

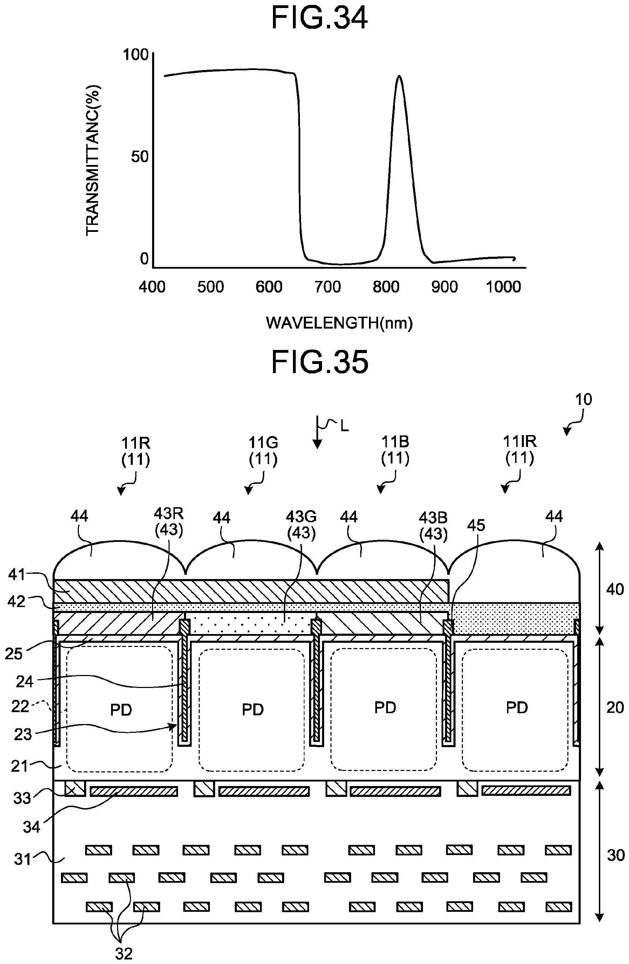

In addition, as illustrated in FIG. 34, the spectral characteristic of the IR cut filter 41 may transmit infrared light having wavelengths of 800 (nm) to 900 (nm) in addition to visible light.

As described above, by determining the absorption maximum wavelength by the coloring material added to the IR cut filter 41, the IR cut filter 41 can be an optical filter that selectively absorbs infrared light in a predetermined wavelength region in the visible light pixel. In addition, the absorption maximum wavelength of the IR cut filter 41 can be appropriately determined according to the application of the solid-state imaging element 1.

<15th modification>

In the embodiment and various modifications described so far, an example in which the IR cut filter 41 is provided on the surface on the light incident side of the semiconductor layer 20 has been described, but the arrangement of the IR cut filter 41 in the present disclosure is not limited to such an example. FIG. 35 is a cross-sectional view schematically illustrating a structure of a pixel array unit 10 according to a 15th modification of the embodiment of the present disclosure.

As illustrated in FIG. 35, in the pixel array unit 10 of the 15th modification, the IR cut filter 41 and the color filter 43 are arranged to be interchanged. That is, in the 15th modification, the color filter 43 is arranged on the surface on the light incident side of the semiconductor layer 20 in the visible light pixel (R pixel 11R, G pixel 11G, and B pixel 11B).

In addition, the planarizing film 42 is provided to planarize the surface on which the IR cut filter 41 and the OCL 44 are formed, and to avoid unevenness occurring in the rotational coating process when the IR cut filter 41 and the OCL 44 are formed.

Then, the IR cut filters 41 are arranged on the surface on the light incident side of the planarizing film 42 in the visible light pixel (R pixel 11R, G pixel 11G, and B pixel 11B).

Also by this, the quality of the signal output from the pixel array unit 10 can be improved by providing the IR cut filter 41 only in the visible light pixel.

<16th modification>

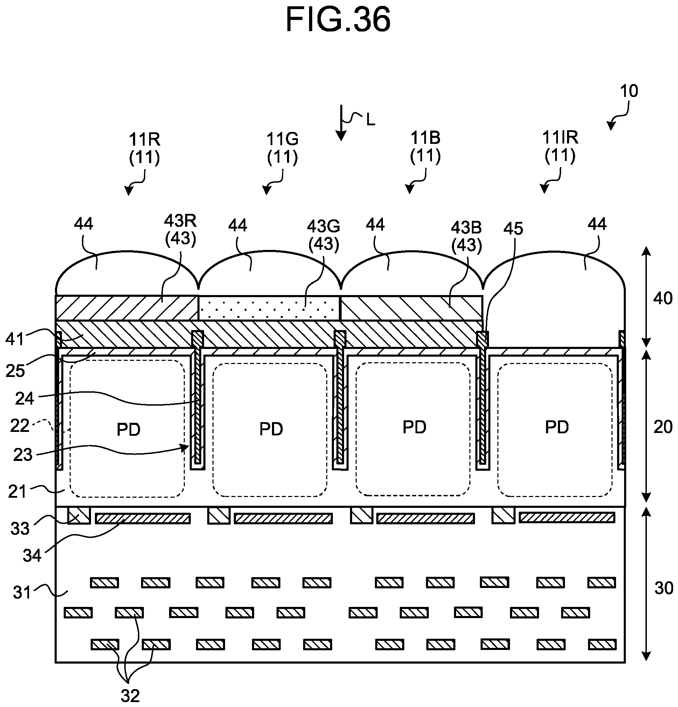

FIG. 36 is a cross-sectional view schematically illustrating a structure of a pixel array unit 10 according to a 16th modification of the embodiment of the present disclosure. As illustrated in FIG. 36, in the pixel array unit 10 of the 16th modification, the planarizing film 42 for planarizing the surface after the IR cut filter 41 is formed is omitted.

That is, in the 16th modification, the color filter 43 is arranged on the surface on the light incident side of the IR cut filter 41 in the visible light pixel (R pixel 11R, G pixel 11G, and B pixel 11B).

Also by this, the quality of the signal output from the pixel array unit 10 can be improved by providing the IR cut filter 41 only in the visible light pixel.

<17th modification>

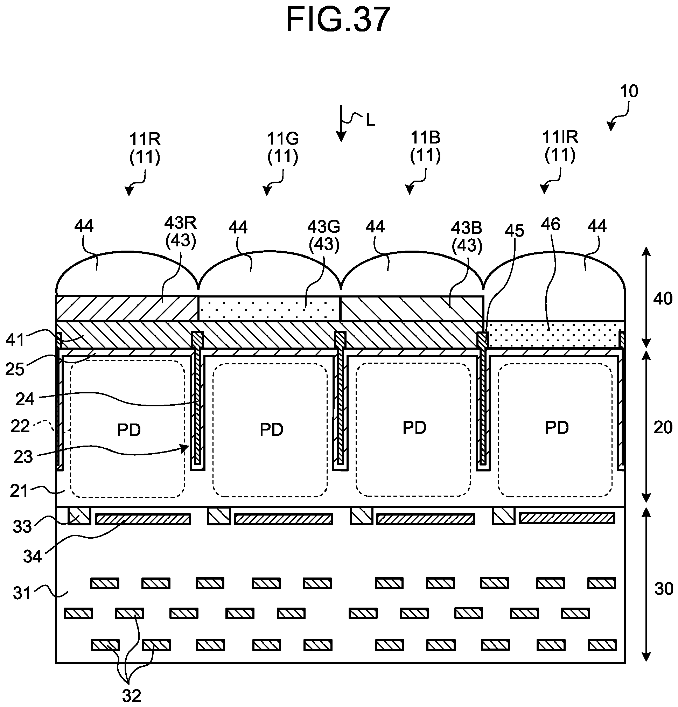

FIG. 37 is a cross-sectional view schematically illustrating a structure of a pixel array unit 10 according to a 17th modification of the embodiment of the present disclosure. As illustrated in FIG. 37, in the pixel array unit 10 of the 17th modification, similarly to the 16th modification described above, the planarizing film 42 for planarizing the surface after the IR cut filter 41 is formed is omitted.

In addition, in the 17th modification, a transparent material 46 is provided between the metal oxide film 25 and the OCL 44 of the semiconductor layer 20 in the IR pixel 11IR. The transparent material 46 has an optical characteristic of transmitting at least infrared light, and is formed in a photolithography process after the IR cut filter 41 is formed.

Also by this, the quality of the signal output from the pixel array unit 10 can be improved by providing the IR cut filter 41 only in the visible light pixel.

<18th modification>

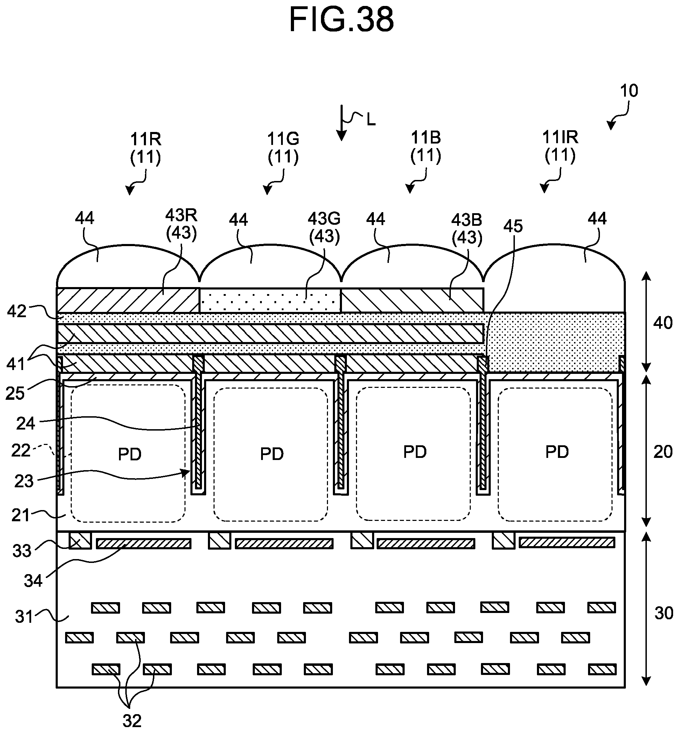

FIG. 38 is a cross-sectional view schematically illustrating a structure of a pixel array unit 10 according to an 18th modification of the embodiment of the present disclosure. As illustrated in FIG. 38, in the pixel array unit 10 of the 18th modification, the IR cut filter 41 has multiple layers (two layers in the drawing).

The multi-layered IR cut filter 41 can be formed, for example, by repeating a process of forming the single-layered IR cut filter 41 and a process of planarizing the surface with the planarizing film 42.

Here, if the single-layered IR cut filter 41 having a large film thickness is to be planarized by the planarizing film 42, unevenness may occur in the planarizing film 42 when the planarizing film 42 is formed.

However, in the 18th modification, since the IR cut filter 41 having a small film thickness is planarized by the planarizing film 42, the occurrence of unevenness in the planarizing film 42 can be suppressed. Furthermore, in the 18th modification, the total film thickness of the IR cut filter 41 can be increased by making the IR cut filter 41 multilayered.

Therefore, according to the 18th modification, the pixel array unit 10 can be formed with high accuracy, and the quality of the signal output from the pixel array unit 10 can be further improved.

<19th modification>

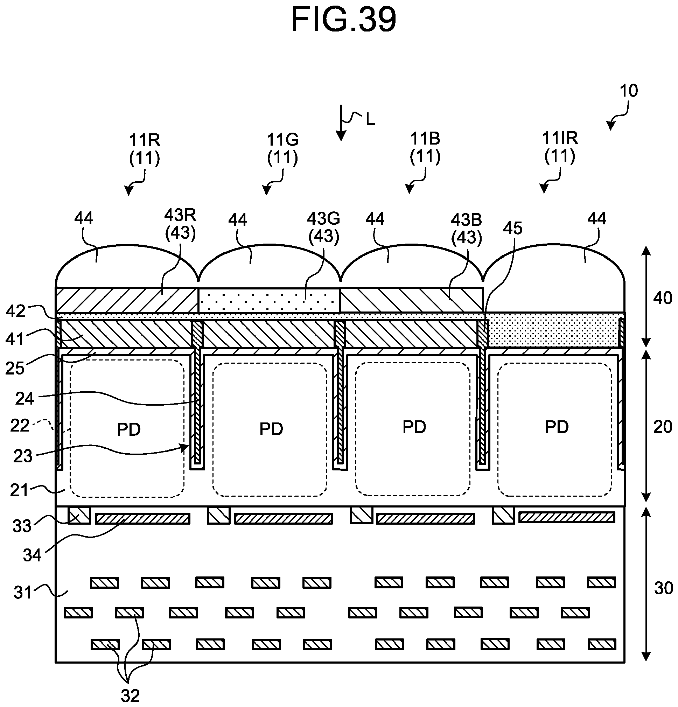

FIG. 39 is a cross-sectional view schematically illustrating a structure of a pixel array unit 10 according to a 19th modification of the embodiment of the present disclosure. As illustrated in FIG. 39, in the pixel array unit 10 of the 19th modification, the light shielding wall 45 is provided to penetrate the IR cut filter 41.

As a result, it is possible to suppress incidence of light transmitted through the IR cut filter 41 and the planarizing film 42 of the adjacent unit pixels 11, and thus, it is possible to further suppress occurrence of color mixing.

<20th modification>

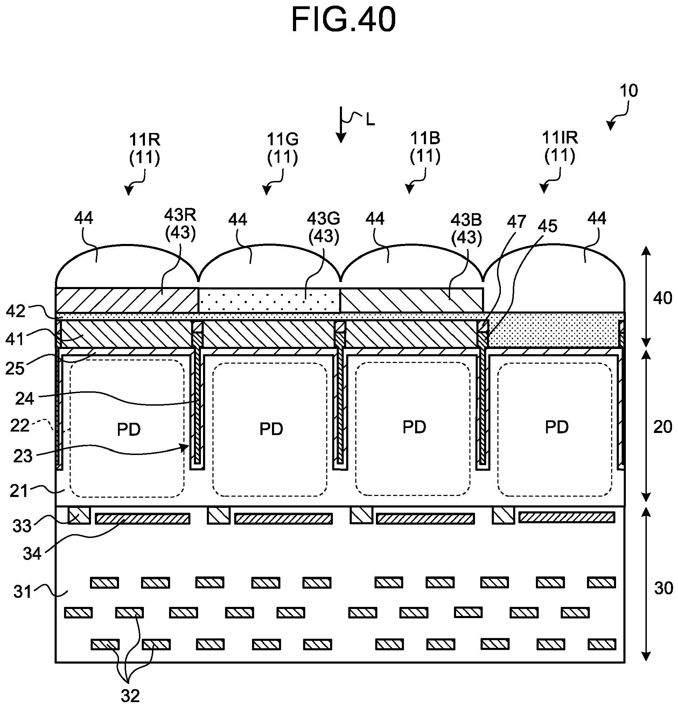

FIG. 40 is a cross-sectional view schematically illustrating a structure of a pixel array unit 10 according to a 20th modification of the embodiment of the present disclosure. As illustrated in FIG. 40, in the pixel array unit 10 of the 20th modification, an optical wall 47 is provided on the light incident side of the light shielding wall 45. Then, in the 20th modification, the integrated light shielding wall 45 and optical wall 47 are provided to penetrate the IR cut filter 41.

The optical wall 47 is made of a material having a low refractive index (for example, $n \leq 1.6$), and is made of, for example, silicon oxide or an organic material having a low refractive index.

Also by this, it is possible to suppress incidence of light transmitted through the IR cut filter 41 and the planarizing film 42 of the adjacent unit pixels 11, and thus, it is possible to further suppress occurrence of color mixing.

<21st modification>

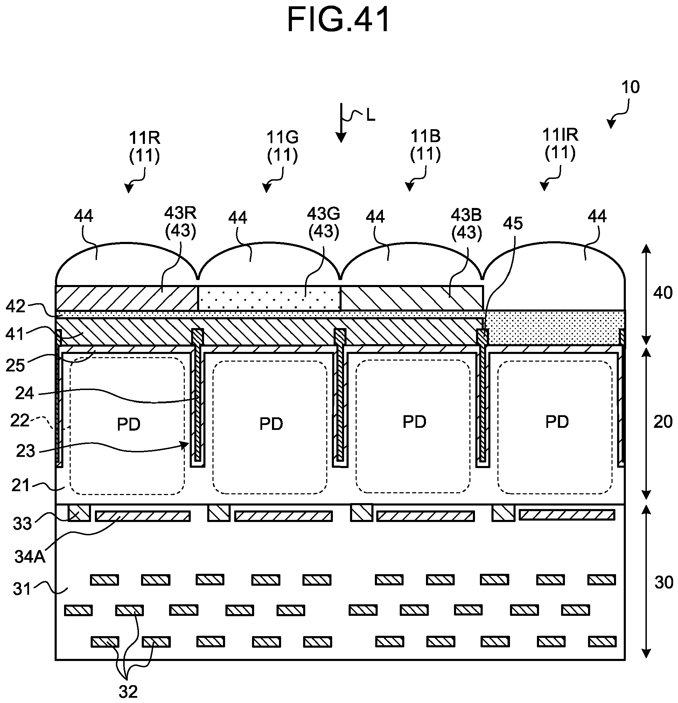

FIG. 41 is a cross-sectional view schematically illustrating a structure of a pixel array unit 10 according to a 21st modification of the embodiment of the present disclosure. As illustrated in FIG. 41, in the pixel array unit 10 of the 21st modification, an optical filter reflection layer 34A is provided in the wiring layer 30 instead of the metal layer 34.

The optical filter reflection layer 34A is formed of, for example, a dielectric multilayer film, and has a reflectance of a given value (for example, 80 (%)) or more. In addition, the optical filter reflection layer 34A is arranged in each unit pixel 11, and is provided on the light incident side of the plurality of layers of wiring 32.

Also by this, the light L that has passed through the photodiode PD of the IR pixel 11IR can be suppressed from reaching the wiring 32 of the wiring layer 30. Therefore, according to the 21st modification, since it is possible to suppress the stray light Ls (see FIG. 5) reflected by the wiring 32 from leaking into the adjacent unit pixel 11, it is possible to suppress the occurrence of color mixing.

In addition, in the 21st modification, since the optical filter reflection layer 34A having a higher reflectance than the metal layer 34 made of tungsten can be used, the light L reflected by the optical filter reflection layer 34A can be efficiently returned to the IR pixel 11IR. Therefore, according to the 21st modification, the sensitivity of the IR pixel 11IR can be improved.

<22nd modification>

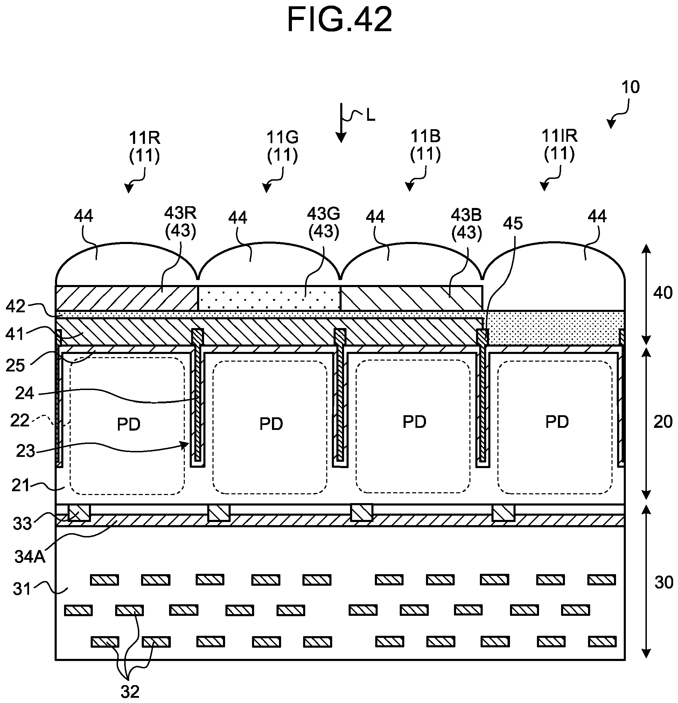

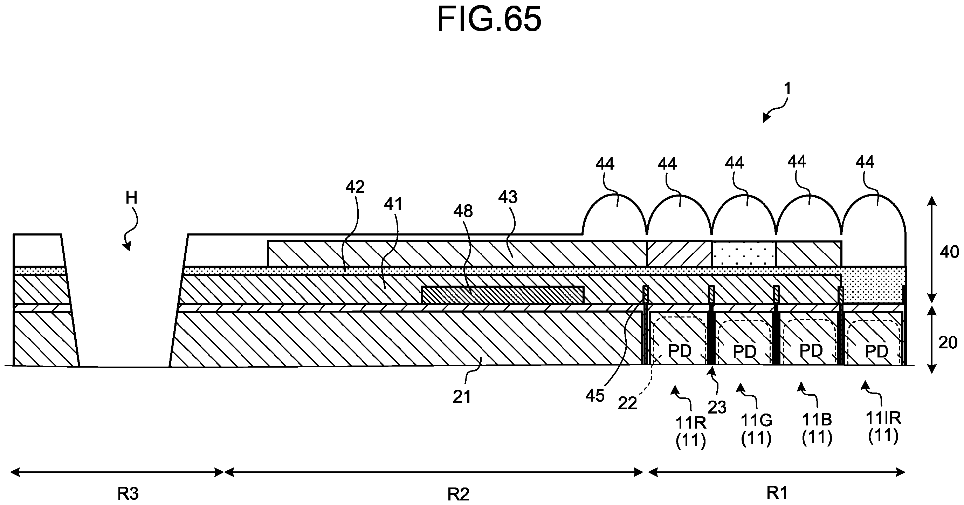

FIG. 42 is a cross-sectional view schematically illustrating a structure of a pixel array unit 10 according to a 22nd modification of the embodiment of the present disclosure. As illustrated in FIG. 42, in the pixel array unit 10 of the 22nd modification, the optical filter reflection layer 34A is not individually arranged in the unit pixel 11, but is integrally provided in an entire pixel region R1 (see FIG. 65).

Also by this, the light L that has passed through the photodiode PD of the IR pixel 11IR can be suppressed from reaching the wiring 32 of the wiring layer 30. Therefore, according to the 22nd modification, since it is possible to suppress the stray light Ls (see FIG. 5) reflected by the wiring 32 from leaking into the adjacent unit pixel 11, it is possible to suppress the occurrence of color mixing.

Note that, since the optical filter reflection layer 34A is formed of a dielectric multilayer film, there is no possibility that the adjacent pixel transistors 33 are short-circuited even if the optical filter reflection layer 34A and the pixel transistors 33 are in contact with each other as illustrated in FIG. 42. That is, in the 22nd modification, the optical filter reflection layer 34A can be arranged without a gap to be in contact with the pixel transistors 33.

Therefore, according to the 22nd modification, since it is possible to further suppress the stray light Ls reflected by the wiring 32 from leaking into the adjacent unit pixel 11, it is possible to further suppress the occurrence of color mixing.

In addition, in the 22nd modification, since the optical filter reflection layer 34A is formed of an insulating film, even if the optical filter reflection layer 34A is in contact with the contact electrode to the diffusion layer of the pixel transistor 33, there is no possibility of short circuit. Therefore, in the 22nd modification, the wiring 32 can be arranged in the wiring layer 30 with a high degree of freedom.

<23rd modification>

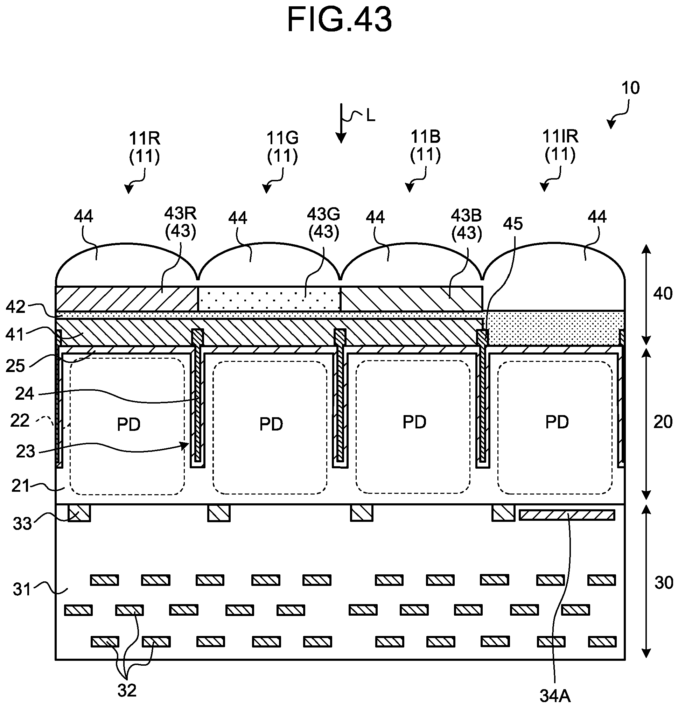

FIG. 43 is a cross-sectional view schematically illustrating a structure of a pixel array unit 10 according to a 23rd modification of the embodiment of the present disclosure. As illustrated in FIG. 43, in the pixel array unit 10 of the 23rd modification, the optical filter reflection layer 34A is not provided in the visible light pixel (R pixel 11R, G pixel 11G, and B pixel 11B), and is provided only in the IR pixel 11IR.

Also by this, the light L that has passed through the photodiode PD of the IR pixel 11IR can be suppressed from reaching the wiring 32 of the wiring layer 30. Therefore, according to the 23rd modification, since it is possible to suppress the stray light Ls (see FIG. 5) reflected by the wiring 32 from leaking into the adjacent unit pixel 11, it is possible to suppress the occurrence of color mixing.

<24th modification>

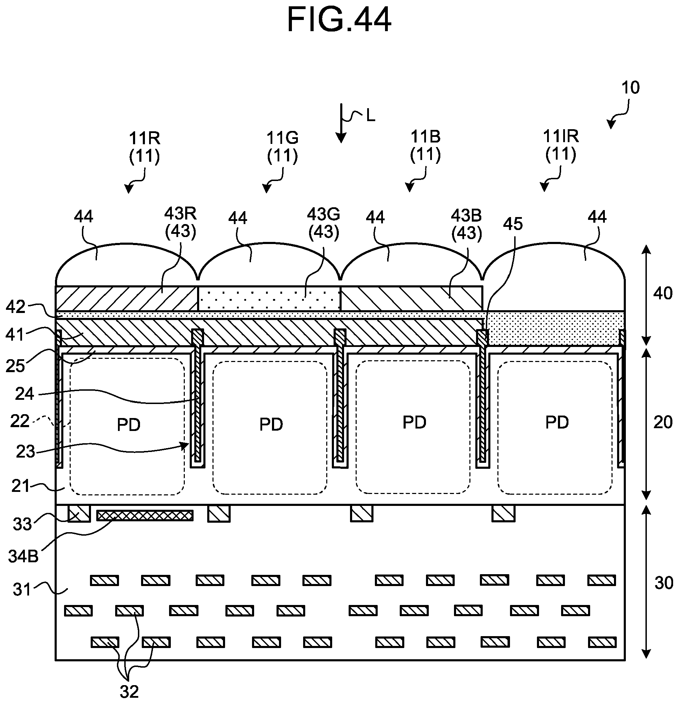

FIG. 44 is a cross-sectional view schematically illustrating a structure of a pixel array unit 10 according to a 24th modification of the embodiment of the present disclosure. In the pixel array unit 10 of the 24th modification, an optical filter reflection layer 34B that selectively reflects only a specific wavelength region is provided in the wiring layer 30.

For example, in the example of FIG. 44, the optical filter reflection layer 34B that selectively reflects only the red wavelength region is provided only in the R pixel 11R.

Also by this, the light L that has passed through the photodiode PD of the R pixel 11R can be suppressed from reaching the wiring 32 of the wiring layer 30. Therefore, according to the 24th modification, the occurrence of color mixing can be suppressed.

In addition, in the 24th modification, by providing the optical filter reflection layer 34B that selectively reflects only the red wavelength region only in the R pixel 11R, it is possible to reflect only the red light without reflecting the infrared light transmitted through the color filter 43R by the optical filter reflection layer 34B.

Therefore, according to the 24th modification, the sensitivity of the red light can be improved in the R pixel 11R, and an increase in unnecessary sensitivity due to the infrared light can be suppressed.

<25th modification>

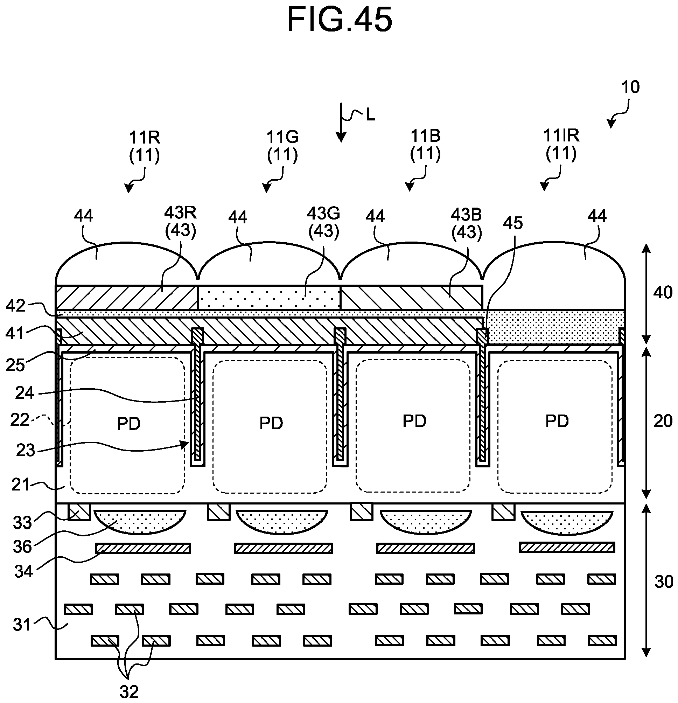

FIG. 45 is a cross-sectional view schematically illustrating a structure of a pixel array unit 10 according to a 25th modification of the embodiment of the present disclosure. As illustrated in FIG. 45, in the pixel array unit 10 of the 25th modification, an on-chip lens 36 is provided on the light incident side of the metal layer 34 in the wiring layer 30. The on-chip lens 36 is a lens that collects the light L on the metal layer 34 of each unit pixel 11.

As a result, in the 25th modification, the reflected light from the metal layer 34 can be reflected to the central region of the photodiode PD located immediately above. That is, in the 25th modification, since it is possible to suppress the reflected light from the metal layer 34 from leaking into the adjacent unit pixel 11, it is possible to suppress the occurrence of color mixing. In addition, the size of the metal layer 34 can be reduced by the light collection effect of the on-chip lens 36.

Note that, in the example of FIG. 45, an example in which the metal layer 34 is arranged in the vicinity of the on-chip lens 36 has been described. However, the present disclosure is not limited to such an example, and for example, the optical filter reflection layers 34A and 34B may be arranged in the vicinity of the on-chip lens 36.

In addition, in the example of FIG. 45, an example in which the metal layer 34 is arranged immediately below the on-chip lens 36 has been described. However, the present disclosure is not limited to such an example, and for example, a configuration in which the wiring 32 is not arranged immediately below the on-chip lens 36 may be adopted. As a result, since the light is narrowed by the on-chip lens 36, it is possible to suppress reflection of the light by the wiring 32, and thus, it is possible to suppress occurrence of color mixing.

<26th modification>

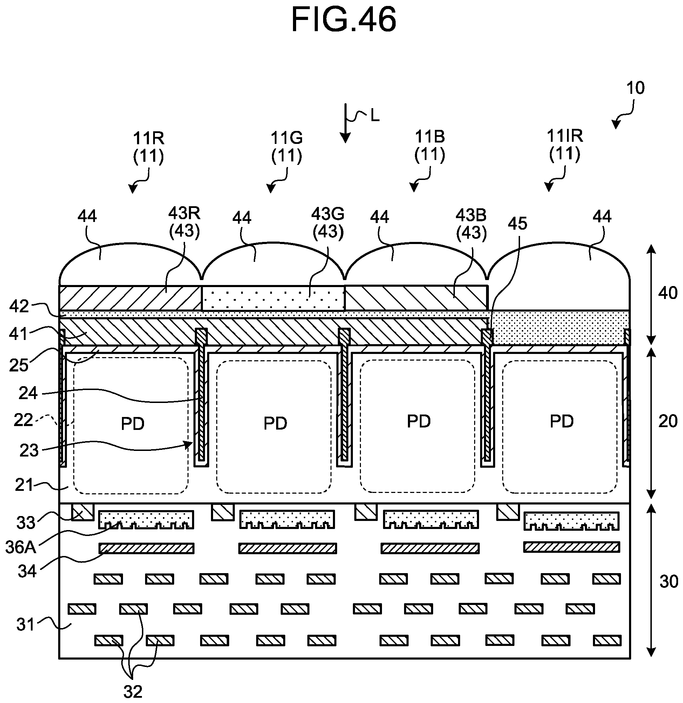

FIG. 46 is a cross-sectional view schematically illustrating a structure of a pixel array unit 10 according to a 26th modification of the embodiment of the present disclosure. As illustrated in FIG. 46, in the pixel array unit 10 of the 26th modification, a meta-lens 36A is provided on the light incident side of the metal layer 34 in the wiring layer 30. The meta-lens 36A is a planar lens having a meta-surface, and is a lens that collects the light L on the metal layer 34 of each unit pixel 11.

As a result, in the 26th modification, the reflected light from the metal layer 34 can be reflected to the central region of the photodiode PD located immediately above. That is, in the 26th modification, since it is possible to suppress the reflected light from the metal layer 34 from leaking into the adjacent unit pixel 11, it is possible to suppress the occurrence of color mixing.

Note that, in the example of FIG. 46, an example in which the metal layer 34 is arranged in the vicinity of the meta-lens 36A has been described. However, the present disclosure is not limited to such an example, and for example, the optical filter reflection layers 34A and 34B may be arranged in the vicinity of the meta-lens 36A.

In addition, in the example of FIG. 46, an example in which the metal layer 34 is arranged immediately below the meta-lens 36A has been described. However, the present disclosure is not limited to such an example, and for example, a configuration in which the wiring 32 is not arranged immediately below the meta-lens 36A may be adopted. As a result, since the light is narrowed by the meta-lens 36A, it is possible to suppress reflection of the light by the wiring 32, and thus, it is possible to suppress occurrence of color mixing.

<27th modification>

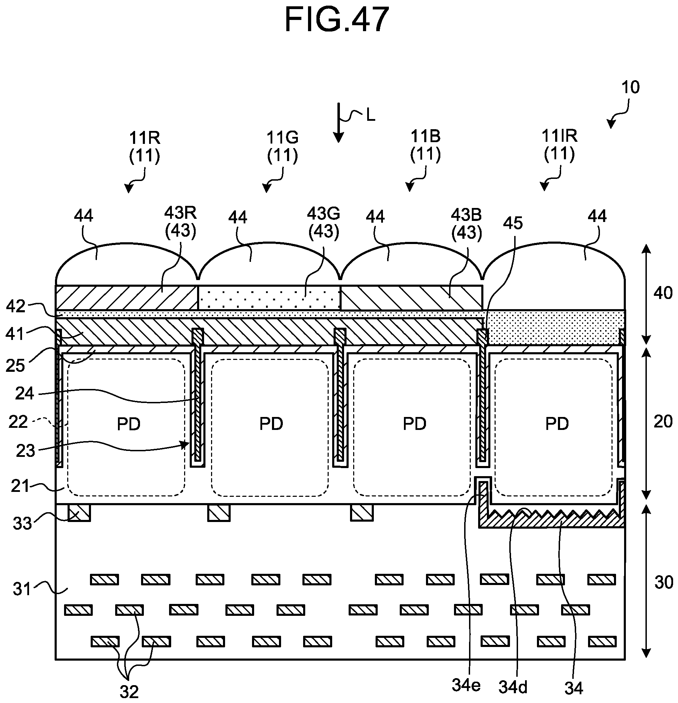

FIG. 47 is a cross-sectional view schematically illustrating a structure of a pixel array unit 10 according to a 27th modification of the embodiment of the present disclosure. As illustrated in FIG. 47, in the pixel array unit 10 of the 27th modification, the metal layer 34 is provided only in the IR pixel 11IR, and the configuration of the metal layer 34 is different from that of the above-described embodiment.

Specifically, the metal layer 34 of the 27th modification includes a plurality of protrusion portions 34d and a side wall portion 34e. The plurality of protrusion portions 34d is arranged on the surface on the light incident side in the metal layer 34. Due to the plurality of protrusion portions 34d, the metal layer 34 of the 27th modification has a rough surface on the light incident side.

The side wall portion 34e is a wall-shaped portion protruding from a peripheral edge portion of the surface on the light incident side in the metal layer 34 toward the light incident side. The side wall portion 34e is arranged to face the light shielding wall 24 surrounding the IR pixel 11IR.

Also by this, the light L that has passed through the photodiode PD of the IR pixel 11IR can be suppressed from reaching the wiring 32 of the wiring layer 30. Therefore, according to the 27th modification, since it is possible to suppress the stray light Ls (see FIG. 5) reflected by the wiring 32 from leaking into the adjacent unit pixel 11, it is possible to suppress the occurrence of color mixing.

In addition, in the 27th modification, by arranging the plurality of protrusion portions 34d on the surface on the light incident side in the metal layer 34, the optical path length of the light reflected by the surface on the light incident side can be extended, in a manner that a saturation charge amount Qs of the photodiode PD can be increased.

In addition, in the 27th modification, the plurality of protrusion portions 34d is arranged on the surface on the light incident side in the metal layer 34, in a manner that the distance between the metal layer 34 and the photodiode PD can be suppressed from being uniform. Therefore, according to the 27th modification, it is possible to improve the robustness of the color mixing ratio variation between the adjacent unit pixels 11.

In addition, in the 27th modification, since the side wall portion 34e is arranged on the surface on the light incident side in the metal layer 34, it is possible to suppress the light reflected by the metal layer 34 from leaking into the adjacent unit pixel 11, and thus, it is possible to suppress the occurrence of color mixing.

In addition, in the 27th modification, since the side wall portion 34e is arranged on the surface on the light incident side in the metal layer 34, the light reflected by the metal layer 34 can be returned to the photodiode PD immediately above, and thus the saturation charge amount Qs of the photodiode PD can be increased.

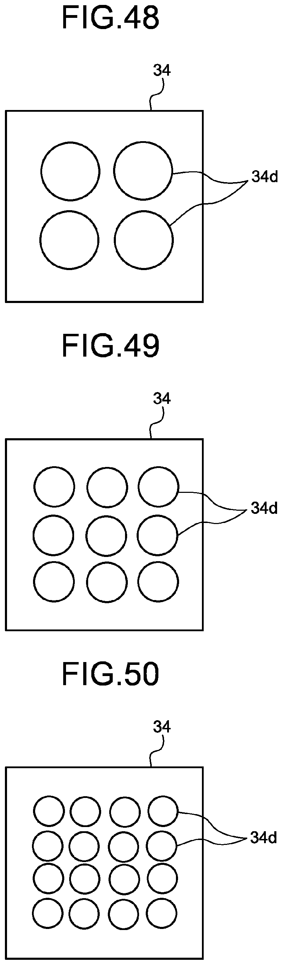

FIGS. 48 to 54 are plan views schematically illustrating an example of arrangement of the protrusion portions 34d according to the 27th modification of the embodiment of the present disclosure. As illustrated in FIG. 48, in the metal layer 34 according to the 27th modification, four protrusion portions 34d may be arranged side by side in two rows and two columns in plan view.

In addition, as illustrated in FIG. 49, in the metal layer 34 according to the 27th modification, nine protrusion portions 34d may be arranged side by side in three rows and three columns in plan view. In addition, as illustrated in FIG. 50, in the metal layer 34 according to the 27th modification, 16 protrusion portions 34d may be arranged side by side in four rows and four columns in plan view.

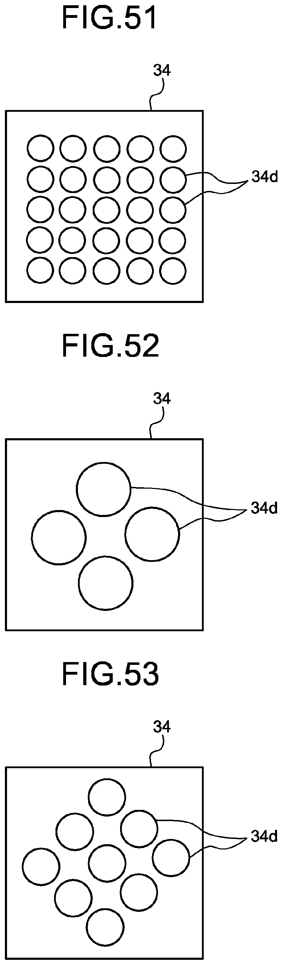

In addition, as illustrated in FIG. 51, in the metal layer 34 according to the 27th modification, 25 protrusion portions 34d may be arranged side by side in five rows and five columns in plan view. In addition, as illustrated in FIG. 52, in the metal layer 34 according to the 27th modification, four protrusion portions 34d may be arranged side by side in two rows and two columns in a rhombus shape in plan view.

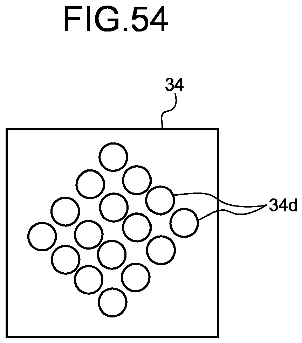

In addition, as illustrated in FIG. 53, in the metal layer 34 according to the 27th modification, nine protrusion portions 34d may be arranged side by side in three rows and three columns in a rhombus shape in plan view. In addition, as illustrated in FIG. 54, in the metal layer 34 according to the 27th modification, 16 protrusion portions 34d may be arranged side by side in four rows and four columns in a rhombus shape in plan view.

<28th modification>

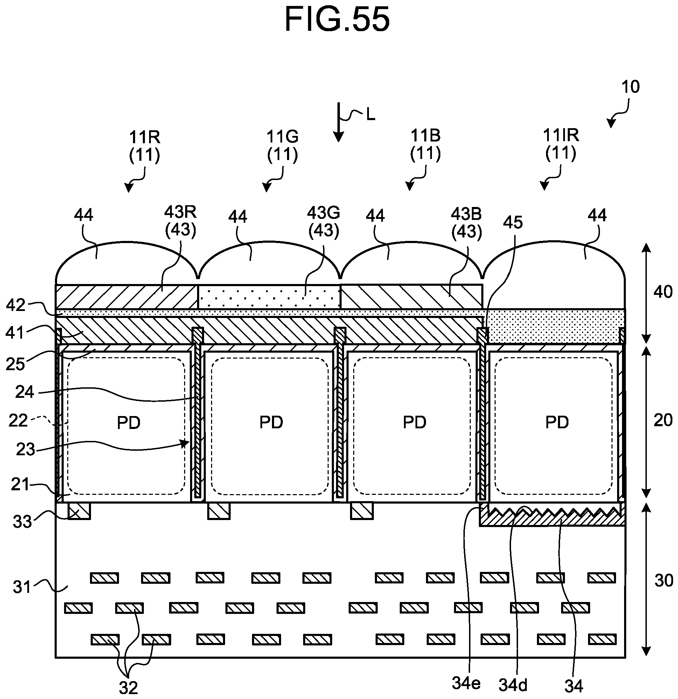

FIG. 55 is a cross-sectional view schematically illustrating a structure of a pixel array unit 10 according to a 28th modification of the embodiment of the present disclosure. As illustrated in FIG. 55, in the pixel array unit 10 of the 28th modification, the metal layer 34 has the same configuration as in the 27th modification described above, and the light shielding wall 24 of the separation region 23 is provided to penetrate the semiconductor layer 20.

As a result, since it is possible to further suppress the light L reflected by the metal layer 34 from leaking into the adjacent unit pixel 11, it is possible to further suppress the occurrence of color mixing.

<29th modification>

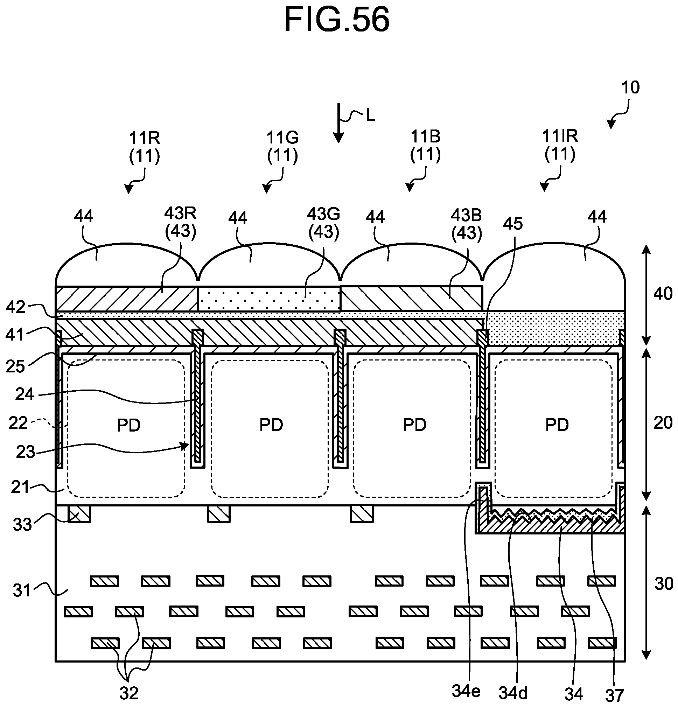

FIG. 56 is a cross-sectional view schematically illustrating a structure of a pixel array unit 10 according to a 29th modification of the embodiment of the present disclosure. As illustrated in FIG. 56, in the pixel array unit 10 of the 29th modification, the metal layer 34 has the same configuration as in the 27th modification described above, and a high reflectance film 37 is provided around the metal layer 34.

The high reflectance film 37 is made of a material (for example, gold, platinum, and the like) having a reflectance higher than that of the metal layer 34 containing tungsten as a main component. The high reflectance film 37 is arranged to cover the surface on the light incident side in the metal layer 34 on which the protrusion portions 34d are arranged, the side wall portion 34e, and the like.

In the 29th modification, by arranging the high reflectance film 37, since a larger amount of light reflected by the metal layer 34 can be returned to the photodiode PD immediately above, the saturation charge amount Qs of the photodiode PD can be further increased.

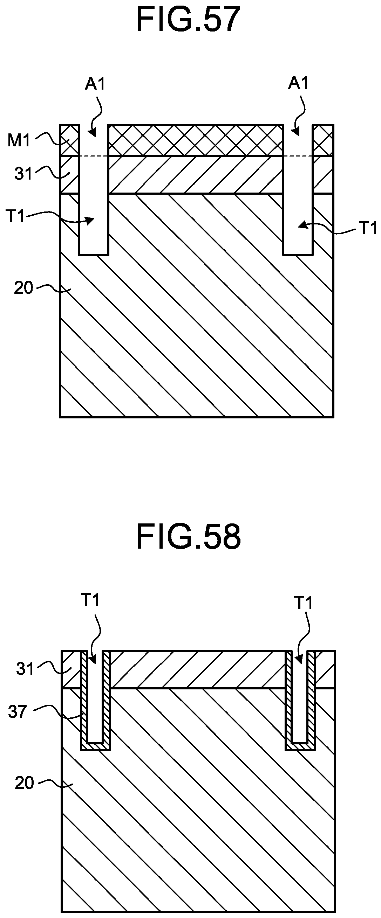

FIGS. 57 to 61 are views for explaining one example of a step of manufacturing the metal layer 34 according to the 29th modification of the embodiment of the present disclosure. First, the interlayer insulating film 31 and a mask M1 are formed on the surface of the semiconductor layer 20.

Next, a predetermined opening A1 is formed in the mask M1, and a trench T1 is formed in the semiconductor layer 20 and the interlayer insulating film 31 as illustrated in FIG. 57 by digging the mask M1 from above by anisotropic etching such as reactive ion etching (RIE) .

Next, after the mask M1 is removed, the high reflectance film 37 is formed on the surfaces of the semiconductor layer 20 and the interlayer insulating film 31 using a known method. Then, the high reflectance film 37 formed on the surface of the interlayer insulating film 31 is polished by a method such as chemical mechanical polishing (CMP), in a manner that the high reflectance film 37 is formed on the inner wall surface of the trench T1 as illustrated in FIG. 58.

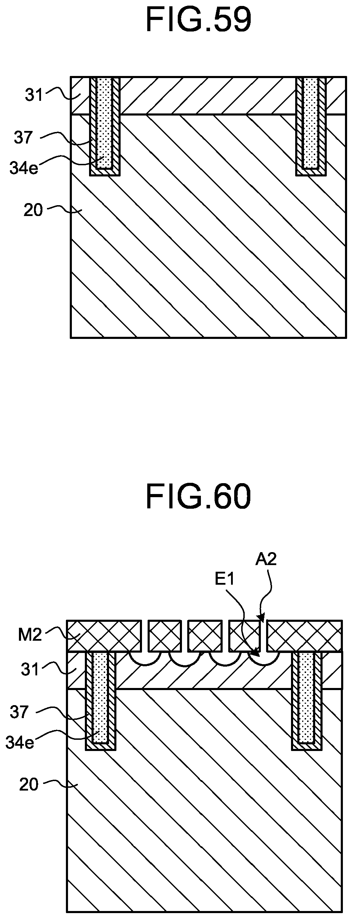

Next, the metal layer 34 is formed on the surfaces of the semiconductor layer 20 and the interlayer insulating film 31 using a known method. Then, the metal layer 34 formed on the surface of the interlayer insulating film 31 is polished by a method such as chemical mechanical polishing (CMP), in a manner that the side wall portion 34e is formed inside the trench T1 as illustrated in FIG. 59.

Next, the mask M2 having a predetermined opening A2 is formed, a hemispherical concave portion E1 is formed in the interlayer insulating film 31 as illustrated in FIG. 60 by digging the mask M2 from above by anisotropic etching.

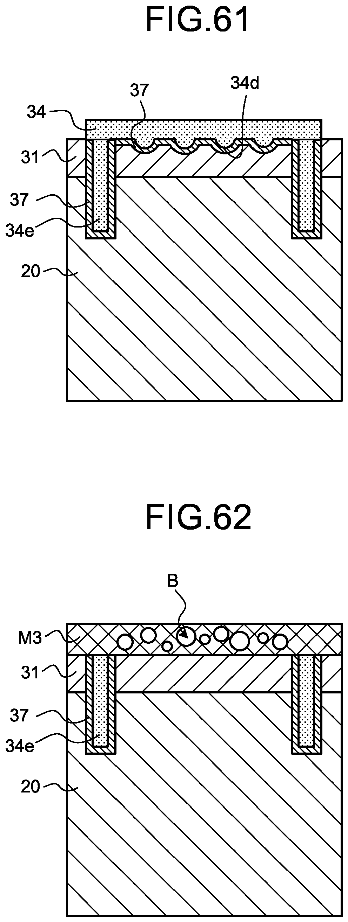

Next, after the mask M2 is removed, the high reflectance film 37 and the metal layer 34 are formed on the surface of the interlayer insulating film 31, in a manner that the metal layer 34 having the protrusion portions 34d and the side wall portion 34e is formed as illustrated in FIG. 61.

FIGS. 62 to 64 are views for explaining another example of a step of manufacturing the metal layer 34 according to the 29th modification of the embodiment of the present disclosure. In this other example, the steps up to FIG. 59 are similar to those in the above example, and thus the description is omitted.

Subsequently to the processes up to FIG. 59, in another example, as illustrated in FIG. 62, a mask M3 including bubbles B is formed on the surface of the interlayer insulating film 31. The mask M3 is, for example, a sparse oxide film.

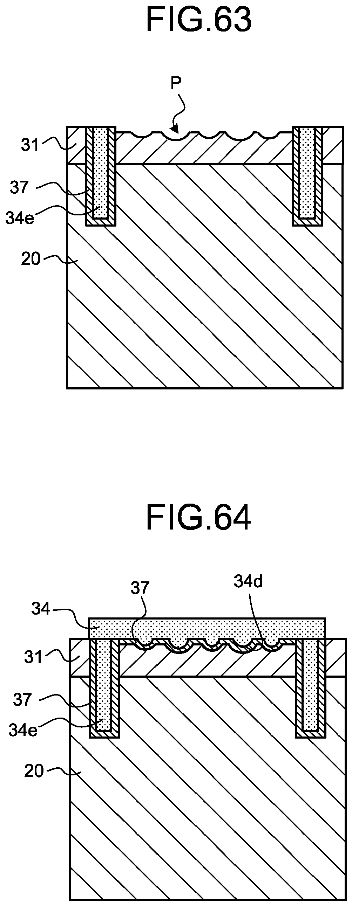

Next, the mask M3 is removed by etching back the entire surface. As a result, as illustrated in FIG. 63, unevenness P caused by the bubbles B is formed on the surface of the interlayer insulating film 31. Then, the high reflectance film 37 and the metal layer 34 are formed on the surface of the interlayer insulating film 31, in a manner that the metal layer 34 having the protrusion portions 34d and the side wall portion 34e is formed as illustrated in FIG. 64.

<Peripheral structure of solid-state imaging element>

FIG. 65 is a cross-sectional view schematically illustrating a peripheral structure of the solid-state imaging element 1 according to an embodiment of the present disclosure, and mainly illustrates a cross-sectional structure of a peripheral portion of the solid-state imaging element 1. As illustrated in FIG. 65, the solid-state imaging element 1 includes a pixel region R1, a peripheral region R2, and a pad region R3.

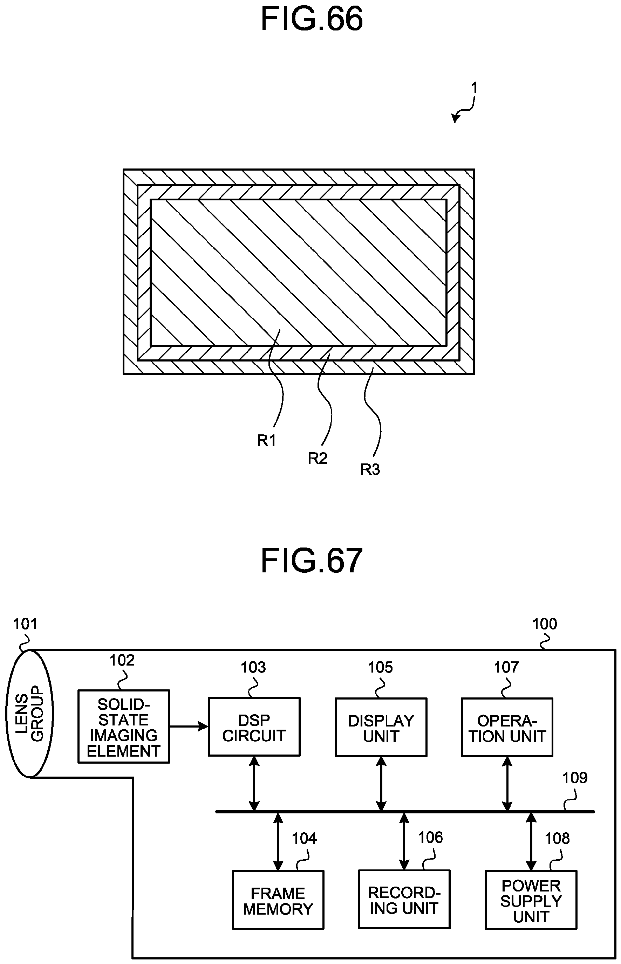

The pixel region R1 is a region where the unit pixel 11 is provided. In the pixel region R1, a plurality of unit pixels 11 is arranged in a two-dimensional lattice pattern. In addition, as illustrated in FIG. 66, the peripheral region R2 is a region provided to surround four sides of the pixel region R1. FIG. 66 is a view illustrating a planar configuration of the solid-state imaging element 1 according to an embodiment of the present disclosure.

In addition, as illustrated in FIG. 65, a light shielding layer 48 is provided in the peripheral region R2. The light shielding layer 48 is a film that shields light obliquely incident from the peripheral region R2 toward the pixel region R1.

By providing such a light shielding layer 48, it is possible to suppress incidence of light L from the peripheral region R2 to the unit pixel 11 of the pixel region R1, and thus, it is possible to suppress occurrence of color mixing. The light shielding layer 48 is made of, for example, aluminum, tungsten, and the like.

As illustrated in FIG. 66, the pad region R3 is a region provided around peripheral region R2. In addition, as illustrated in FIG. 65, the pad region R3 has a contact hole H. A bonding pad (not illustrated) is provided at the bottom of the contact hole H.

Then, by bonding a bonding wire and the like to the bonding pad via the contact hole H, the pixel array unit 10 and each part of the solid-state imaging element 1 are electrically connected.

Here, in the embodiment, as illustrated in FIG. 65, the IR cut filter 41 is preferably formed not only in the pixel region R1 but also in the peripheral region R2 and the pad region R3.

As a result, it is possible to further suppress incidence of infrared light from the peripheral region R2 and the pad region R3 to the unit pixel 11 of the pixel region R1. Therefore, according to the embodiment, the occurrence of color mixing can be suppressed.

In addition, in the embodiment, by forming the IR cut filter 41 also in the peripheral region R2 and the pad region R3, it is possible to suppress the occurrence of unevenness in the planarizing film 42 in the peripheral region R2 and the pad region R3 when the planarizing film 42 is formed. Therefore, according to the embodiment, the solid-state imaging element 1 can be accurately formed.

In the embodiment and various modifications described above, an example in which the visible light pixels (R pixel 11R, G pixel 11G, and B pixel 11B) and the IR pixels 11IR are arranged side by side in the pixel array unit 10 has been described. However, light receiving pixels having other functions may be added to the pixel array unit 10.

For example, a light receiving pixel (hereinafter, also referred to as a phase difference pixel) for phase difference detection may be added to the pixel array unit 10 according to the embodiment, and the metal layer 34 containing tungsten as a main component may be provided in the phase difference pixel.

As a result, color mixing caused in the phase difference pixel due to the IR pixel 11IR can be suppressed, in a manner that the autofocus performance of the solid-state imaging element 1 can be improved.

In addition, a light receiving pixel (hereinafter, also referred to as a distance measuring pixel) for distance measurement using a time of flight (ToF) format may be added to the pixel array unit 10 according to the embodiment, and the metal layer 34 containing tungsten as a main component may be provided in the distance measuring pixel.

As a result, color mixing caused in the distance measuring pixel due to the IR pixel 11IR can be suppressed, in a manner that the distance measuring performance of the solid-state imaging element 1 can be improved.

<Effects>

The solid-state imaging element 1 according to the embodiment includes the first light receiving pixel (R pixel 11R, G pixel 11G, and B pixel 11B), the second light receiving pixel (IR pixel 11IR), and the metal layer 34. The first light receiving pixel (R pixel 11R, G pixel 11G, and B pixel 11B) receives visible light. The second light receiving pixel (IR pixel 11IR) receives infrared light. The metal layer 34 is provided to face at least one of the photoelectric conversion unit (photodiode PD) of the first light receiving pixel and the photoelectric conversion unit (photodiode PD) of the second light receiving pixel on the opposite side of the light incident side, and contains tungsten as a main component.

As a result, the occurrence of color mixing caused by the IR pixel 11IR can be suppressed.

In addition, in the solid-state imaging element 1 according to the embodiment, the metal layer 34 is provided to face the photoelectric conversion unit (photodiode PD) of the second light receiving pixel (IR pixel 11IR).

As a result, the occurrence of color mixing caused by the IR pixel 11IR can be suppressed.

In addition, in the solid-state imaging element 1 according to the embodiment, the metal layer 34 is provided to face the photoelectric conversion unit (photodiode PD) of the first light receiving pixel (R pixel 11R, G pixel 11G, and B pixel 11B).

As a result, the occurrence of color mixing caused by the IR pixel 11IR can be suppressed.

In addition, in the solid-state imaging element 1 according to the embodiment, the metal layer 34 is a multilayer (metal layers 34a, 34b, and 34c).

As a result, the occurrence of color mixing caused by the IR pixel 11IR can further be suppressed.

In addition, in the solid-state imaging element 1 according to the embodiment, the metal layer 34 has the gap 34g in plan view.

As a result, optical interference due to variations in film thickness between the semiconductor layer 20 and the metal layer 34 can be suppressed.

In addition, the solid-state imaging element 1 according to the embodiment includes the semiconductor layer 20 and the wiring layer 30. In the semiconductor layer 20, the photoelectric conversion unit (photodiode PD) of the first light receiving pixel (R pixel 11R, G pixel 11G, and B pixel 11B) and the photoelectric conversion unit (photodiode PD) of the second light receiving pixel (IR pixel 11IR) are provided. The wiring layer 30 is provided on the surface on the opposite side of the light incident side of the semiconductor layer 20, and includes the plurality of layers of wiring 32. In addition, the metal layer 34 is provided on the light incident side of the plurality of layers of wiring 32 in the wiring layer 30.

As a result, the occurrence of color mixing caused by the IR pixel 11IR can be suppressed.

In addition, in the solid-state imaging element 1 according to the embodiment, the wiring layer 30 includes the plurality of pixel transistors 33 respectively connected to the photoelectric conversion unit of the first light receiving pixel (R pixel 11R, G pixel 11G, and B pixel 11B) and the photoelectric conversion unit of the second light receiving pixel (IR pixel 11IR). In addition, the metal layer 34 is arranged not to overlap the pixel transistor 33 in plan view.

As a result, the manufacturing cost of the pixel array unit 10 can be reduced.

In addition, in the solid-state imaging element 1 according to the embodiment, the wiring layer 30 includes the plurality of pixel transistors 33 respectively connected to the photoelectric conversion unit of the first light receiving pixel (R pixel 11R, G pixel 11G, and B pixel 11B) and the photoelectric conversion unit of the second light receiving pixel (IR pixel 11IR). In addition, the metal layer 34 is arranged to ride on the opposite side of the light incident side of the pixel transistor 33.

As a result, the occurrence of color mixing caused by the IR pixel 11IR can further be suppressed.

In addition, in the solid-state imaging element 1 according to the embodiment, the wiring layer 30 includes a lens (on-chip lens 36, meta-lens 36A) provided on the light incident side of the metal layer 34.

As a result, the occurrence of color mixing caused by the IR pixel 11IR can be suppressed.

In addition, in the solid-state imaging element 1 according to the embodiment, the metal layer 34 includes the plurality of protrusion portions 34d arranged on the surface on the light incident side, and a wall-shaped side wall portion 34e protruding from the peripheral edge portion of the surface on the light incident side toward the light incident side.

As a result, the occurrence of color mixing caused by the IR pixel 11IR can be suppressed, and the saturation charge amount Qs of the photodiode PD can be increased.

In addition, in the solid-state imaging element 1 according to the embodiment, the wiring layer 30 includes the high reflectance film 37 arranged to cover the surface on the light incident side in the metal layer 34.

As a result, the saturation charge amount Qs of the photodiode PD can be further increased.

In addition, the solid-state imaging element 1 according to the embodiment includes the semiconductor layer 20 and the wiring layer 30. In the semiconductor layer 20, the photoelectric conversion unit (photodiode PD) of the first light receiving pixel (R pixel 11R, G pixel 11G, and B pixel 11B) and the photoelectric conversion unit (photodiode PD) of the second light receiving pixel (IR pixel 11IR) are provided. The wiring layer 30 is provided on the surface on the opposite side of the light incident side of the semiconductor layer 20, and includes the plurality of layers of wiring 32. In addition, the metal layer 34 is provided on the semiconductor layer 20.

As a result, the occurrence of color mixing caused by the IR pixel 11IR can be suppressed.

In addition, in the solid-state imaging element 1 according to the embodiment, the metal layer 34 is connected to the ground potential.

As a result, the pixel array unit 10 can be stably manufactured.

In addition, the solid-state imaging element 1 according to the embodiment includes the first light receiving pixel (R pixel 11R, G pixel 11G, and B pixel 11B), the second light receiving pixel (IR pixel 11IR), and the optical filter reflection layer 34A (34B). The first light receiving pixel (R pixel 11R, G pixel 11G, and B pixel 11B) receives visible light. The second light receiving pixel (IR pixel 11IR) receives infrared light. The optical filter reflection layer 34A (34B) is provided to face at least one of the photoelectric conversion unit (photodiode PD) of the first light receiving pixel and the photoelectric conversion unit (photodiode PD) of the second light receiving pixel on the opposite side of the light incident side, and has a reflectance of a given value or more.

As a result, the occurrence of color mixing caused by the IR pixel 11IR can be suppressed.

In addition, in the solid-state imaging element 1 according to the embodiment, the optical filter reflection layer 34A (34B) is provided over the entire pixel region R1.

As a result, the occurrence of color mixing caused by the IR pixel 11IR can further be suppressed.

<Electronic device>

Note that the present disclosure is not limited to application to a solid-state imaging element. That is, the present disclosure is applicable to all electronic devices having a solid-state imaging element, such as a camera module, an imaging device, a mobile terminal device having an imaging function, or a copying machine using a solid-state imaging element in an image reading unit, in addition to the solid-state imaging element.

Examples of such an imaging device include a digital still camera and a video camera. In addition, examples of the portable terminal device having such an imaging function include a smartphone and a tablet terminal.

FIG. 67 is a block view illustrating a configuration example of an imaging device as an electronic device 100 to which the technology according to the present disclosure is applied. The electronic device 100 in FIG. 67 is, for example, an electronic device such as an imaging device such as a digital still camera or a video camera, or a mobile terminal device such as a smartphone or a tablet terminal.

In FIG. 67, the electronic device 100 includes a lens group 101, a solid-state imaging element 102, a DSP circuit 103, a frame memory 104, a display unit 105, a recording unit 106, an operation unit 107, and a power supply unit 108.

In addition, in the electronic device 100, the DSP circuit 103, the frame memory 104, the display unit 105, the recording unit 106, the operation unit 107, and the power supply unit 108 are mutually connected via a bus line 109.

The lens group 101 captures incident light (image light) from a subject and forms an image on an imaging surface of the solid-state imaging element 102. The solid-state imaging element 102 corresponds to the solid-state imaging element 1 according to the above-described embodiment, and converts the amount of incident light imaged on the imaging surface by the lens group 101 into an electrical signal in units of pixels and outputs the electrical signal as a pixel signal.

The DSP circuit 103 is a camera signal processing circuit that processes a signal supplied from the solid-state imaging element 102. The frame memory 104 temporarily holds the image data processed by the DSP circuit 103 in units of frames.

The display unit 105 includes, for example, a panel type display device such as a liquid crystal panel or an organic electro luminescence (EL) panel, and displays a moving image or a still image captured by the solid-state imaging element 102. The recording unit 106 records image data of a moving image or a still image captured by the solid-state imaging element 102 on a recording medium such as a semiconductor memory or a hard disk.

The operation unit 107 issues operation commands for various functions of the electronic device 100 in accordance with an operation by a user. The power supply unit 108 appropriately supplies various power sources serving as operation power sources of the DSP circuit 103, the frame memory 104, the display unit 105, the recording unit 106, and the operation unit 107 to these supply targets.

In the electronic device 100 configured as described above, by applying the solid-state imaging element 1 of each of the above-described embodiments as the solid-state imaging element 102, it is possible to suppress the occurrence of color mixing caused by the IR pixel 11IR.

Although the embodiments of the present disclosure have been described above, the technical scope of the present disclosure is not limited to the above-described embodiments as it is, and various modifications can be made without departing from the gist of the present disclosure. In addition, components of different embodiments and modifications may be appropriately combined.

In addition, the effects described in the present specification are merely examples and are not limited, and other effects may be provided.

Note that the present technology can also have the configuration below.

(1) A solid-state imaging element comprising:

a first light receiving pixel that receives visible light;
a second light receiving pixel that receives infrared light; and
a metal layer provided to face at least one of a photoelectric conversion unit of the first light receiving pixel and a photoelectric conversion unit of the second light receiving pixel on an opposite side of a light incident side, the metal layer containing tungsten as a main component.

(2) The solid-state imaging element according to the above (1), wherein
the metal layer is provided to face the photoelectric conversion unit of the second light receiving pixel.
(3) The solid-state imaging element according to the above (1) or (2), wherein
the metal layer is provided to face the photoelectric conversion unit of the first light receiving pixel.
(4) The solid-state imaging element according to any one of the above (1) to (3), wherein
the metal layer is a multilayer.
(5) The solid-state imaging element according to any one of the above (1) to (4), wherein
the metal layer has a gap in plan view.
(6) The solid-state imaging element according to any one of the above (1) to (5), comprising:

a semiconductor layer in which the photoelectric conversion unit of the first light receiving pixel and the photoelectric conversion unit of the second light receiving pixel are provided; and
a wiring layer provided on a surface on an opposite side of a light incident side of the semiconductor layer and having a plurality of layers of wiring, wherein
the metal layer is provided on a light incident side of the plurality of layers of wiring in the wiring layer.

(7) The solid-state imaging element according to the above (6), wherein

the wiring layer includes a plurality of pixel transistors respectively connected to the photoelectric conversion unit of the first light receiving pixel and the photoelectric conversion unit of the second light receiving pixel, and
the metal layer is arranged not to overlap the pixel transistor in plan view.

(8) The solid-state imaging element according to the above (6), wherein

the wiring layer includes a plurality of pixel transistors respectively connected to the photoelectric conversion unit of the first light receiving pixel and the photoelectric conversion unit of the second light receiving pixel, and
the metal layer is arranged to ride on an opposite side of a light incident side of the pixel transistor.

(9) The solid-state imaging element according to the above (6), wherein
the wiring layer includes a lens provided on a light incident side of the metal layer.
(10) The solid-state imaging element according to the above (6), wherein
the metal layer includes a plurality of protrusion portions arranged on a surface on the light incident side, and a wall-shaped side wall portion protruding from a peripheral edge portion of the surface on the light incident side toward the light incident side.

(11) The solid-state imaging element according to the above (10), wherein
the wiring layer includes a high reflectance film arranged to cover a surface on the light incident side in the metal layer.

(12) The solid-state imaging element according to any one of the above (1) to (5), comprising:

a semiconductor layer in which the photoelectric conversion unit of the first light receiving pixel and the photoelectric conversion unit of the second light receiving pixel are provided; and
a wiring layer provided on a surface on an opposite side of a light incident side of the semiconductor layer and having a plurality of layers of wiring, wherein
the metal layer is provided on the semiconductor layer.

(13) The solid-state imaging element according to any one of the above (1) to (12)
, wherein
the metal layer is connected to a ground potential.

(14) A solid-state imaging element comprising:

a first light receiving pixel that receives visible light;
a second light receiving pixel that receives infrared light; and
an optical filter reflection layer provided to face at least one of a photoelectric conversion unit of the first light receiving pixel and a photoelectric conversion unit of the second light receiving pixel on an opposite side of a light incident side, the optical filter reflection layer having a reflectance of a given value or more.

(15) The solid-state imaging element according to the above (14), wherein
the optical filter reflection layer is provided over an entire pixel region.

(16) An electronic device comprising:

a solid-state imaging element;
an optical system that captures incident light from a subject and forms an image on an imaging surface of the solid-state imaging element; and
a signal processing circuit that perform processing on an output signal from the solid-state imaging element, wherein
the solid-state imaging element includes
a first light receiving pixel that receives visible light,
a second light receiving pixel that receives infrared light, and
a metal layer provided to face at least one of a photoelectric conversion unit of the first light receiving pixel and a photoelectric conversion unit of the second light receiving pixel on an opposite side of a light incident side, the metal layer containing tungsten as a main component.

(17) The electronic device according to the above (16), in which
the metal layer is provided to face the photoelectric conversion unit of the second light receiving pixel.

(18) The electronic device according to the above (16) or (17), in which
the metal layer is provided to face the photoelectric conversion unit of the first light receiving pixel.

(19) The electronic device according to any one of the above (16) to (18), in which
the metal layer is a multilayer.

(20) The electronic device according to any one of the above (16) to (19), in which
the metal layer has a gap in plan view.

(21) The electronic device according to any one of the above (16) to (20), including:

a semiconductor layer in which the photoelectric conversion unit of the first light receiving pixel and the photoelectric conversion unit of the second light receiving pixel are provided; and
a wiring layer provided on a surface on an opposite side of a light incident side of the semiconductor layer and having a plurality of layers of wiring, in which
the metal layer is provided on a light incident side of the plurality of layers of wiring in the wiring layer.

(22) The electronic device according to the above (21), in which

the wiring layer includes a plurality of pixel transistors respectively connected to the photoelectric conversion unit of the first light receiving pixel and the photoelectric conversion unit of the second light receiving pixel, and
the metal layer is arranged not to overlap the pixel transistor in plan view.

(23) The electronic device according to the above (21), in which

the wiring layer includes a plurality of pixel transistors respectively connected to the photoelectric conversion unit of the first light receiving pixel and the photoelectric conversion unit of the second light receiving pixel, and the metal layer is arranged to ride on an opposite side of a light incident side of the pixel transistor.

(24) The electronic device according to the above (21), in which
the wiring layer includes a lens provided on a light incident side of the metal layer.
(25) The electronic device according to the above (21), in which
the metal layer includes a plurality of protrusion portions arranged on a surface on the light incident side, and a wall-shaped side wall portion protruding from a peripheral edge portion of the surface on the light incident side toward the light incident side.
(26) The electronic device according to the above (25), in which
the wiring layer includes a high reflectance film arranged to cover a surface on the light incident side in the metal layer.
(27) The electronic device according to any one of the above (16) to (21), including:

a semiconductor layer in which the photoelectric conversion unit of the first light receiving pixel and the photoelectric conversion unit of the second light receiving pixel are provided; and
a wiring layer provided on a surface on an opposite side of a light incident side of the semiconductor layer and having a plurality of layers of wiring, in which
the metal layer is provided on the semiconductor layer.

(28) The electronic device according to any one of the above (16) to (27), in which
the metal layer is connected to a ground potential.
(29) An electronic device including:

a first light receiving pixel that receives visible light;
a second light receiving pixel that receives infrared light; and
an optical filter reflection layer provided to face at least one of a photoelectric conversion unit of the first light receiving pixel and a photoelectric conversion unit of the second light receiving pixel on an opposite side of a light incident side, the optical filter reflection layer having a reflectance of a given value or more.

(30) The electronic device according to the above (29), in which
the optical filter reflection layer is provided over an entire pixel region.

Reference Signs List

1 SOLID-STATE IMAGING ELEMENT
10, 10A PIXEL ARRAY UNIT
11 UNIT PIXEL
11R R PIXEL (EXAMPLE OF FIRST LIGHT RECEIVING PIXEL)
11G G PIXEL (EXAMPLE OF FIRST LIGHT RECEIVING PIXEL)
11B B PIXEL (EXAMPLE OF FIRST LIGHT RECEIVING PIXEL)
11IR IR PIXEL (EXAMPLE OF SECOND LIGHT RECEIVING PIXEL)
20 SEMICONDUCTOR LAYER
30 WIRING LAYER
32 WIRING
33 PIXEL TRANSISTOR
34, 34a TO 34c METAL LAYER
34A, 34B OPTICAL FILTER REFLECTION LAYER
34d PROTRUSION PORTION
34e SIDE WALL PORTION
34g GAP
34r RAISED PORTION
36 ON-CHIP LENS (EXAMPLE OF LENS)
36A META-LENS (EXAMPLE OF LENS)

37 HIGH REFLECTANCE FILM
100 ELECTRONIC DEVICE
PD PHOTODIODE (EXAMPLE OF PHOTOELECTRIC CONVERSION UNIT)

**Claims**

1. A solid-state imaging element comprising:

   a first light receiving pixel that receives visible light;
   a second light receiving pixel that receives infrared light; and
   a metal layer provided to face at least one of a photoelectric conversion unit of the first light receiving pixel and a photoelectric conversion unit of the second light receiving pixel on an opposite side of a light incident side, the metal layer containing tungsten as a main component.

2. The solid-state imaging element according to claim 1, wherein
   the metal layer is provided to face the photoelectric conversion unit of the second light receiving pixel.

3. The solid-state imaging element according to claim 1, wherein
   the metal layer is provided to face the photoelectric conversion unit of the first light receiving pixel.

4. The solid-state imaging element according to claim 1, wherein
   the metal layer is a multilayer.

5. The solid-state imaging element according to claim 1, wherein
   the metal layer has a gap in plan view.

6. The solid-state imaging element according to claim 1, comprising:

   a semiconductor layer in which the photoelectric conversion unit of the first light receiving pixel and the photoelectric conversion unit of the second light receiving pixel are provided; and
   a wiring layer provided on a surface on an opposite side of a light incident side of the semiconductor layer and having a plurality of layers of wiring, wherein
   the metal layer is provided on a light incident side of the plurality of layers of wiring in the wiring layer.

7. The solid-state imaging element according to claim 6, wherein

   the wiring layer includes a plurality of pixel transistors respectively connected to the photoelectric conversion unit of the first light receiving pixel and the photoelectric conversion unit of the second light receiving pixel, and
   the metal layer is arranged not to overlap the pixel transistor in plan view.

8. The solid-state imaging element according to claim 6, wherein

   the wiring layer includes a plurality of pixel transistors respectively connected to the photoelectric conversion unit of the first light receiving pixel and the photoelectric conversion unit of the second light receiving pixel, and
   the metal layer is arranged to ride on an opposite side of a light incident side of the pixel transistor.

9. The solid-state imaging element according to claim 6, wherein
   the wiring layer includes a lens provided on a light incident side of the metal layer.

10. The solid-state imaging element according to claim 6, wherein
    the metal layer includes a plurality of protrusion portions arranged on a surface on the light incident side, and a wall-shaped side wall portion protruding from a peripheral edge portion of the surface on the light incident side toward the light incident side.

11. The solid-state imaging element according to claim 10, wherein
    the wiring layer includes a high reflectance film arranged to cover a surface on the light incident side in the metal layer.

12. The solid-state imaging element according to claim 1, comprising:

a semiconductor layer in which the photoelectric conversion unit of the first light receiving pixel and the photoelectric conversion unit of the second light receiving pixel are provided; and
a wiring layer provided on a surface on an opposite side of a light incident side of the semiconductor layer and having a plurality of layers of wiring, wherein
the metal layer is provided on the semiconductor layer.

13. The solid-state imaging element according to claim 1, wherein
the metal layer is connected to a ground potential.

14. A solid-state imaging element comprising:

a first light receiving pixel that receives visible light;
a second light receiving pixel that receives infrared light; and
an optical filter reflection layer provided to face at least one of a photoelectric conversion unit of the first light receiving pixel and a photoelectric conversion unit of the second light receiving pixel on an opposite side of a light incident side, the optical filter reflection layer having a reflectance of a given value or more.

15. The solid-state imaging element according to claim 14, wherein
the optical filter reflection layer is provided over an entire pixel region.

16. An electronic device comprising:

a solid-state imaging element;
an optical system that captures incident light from a subject and forms an image on an imaging surface of the solid-state imaging element; and
a signal processing circuit that perform processing on an output signal from the solid-state imaging element, wherein
the solid-state imaging element includes
a first light receiving pixel that receives visible light,
a second light receiving pixel that receives infrared light, and
a metal layer provided to face at least one of a photoelectric conversion unit of the first light receiving pixel and a photoelectric conversion unit of the second light receiving pixel on an opposite side of a light incident side,
the metal layer containing tungsten as a main component.

# FIG.1

VERTICAL DRIVE UNIT 13

SYSTEM CONTROL UNIT 12

PIXEL ARRAY UNIT 10

LD  11

LV

COLUMN READOUT CIRCUIT UNIT 14

COLUMN SIGNAL PROCESSING UNIT 15

HORIZONTAL DRIVE UNIT 16

SIGNAL PROC-ESSING UNIT 17

OUTPUT IMAGE

1

# FIG.2

# FIG.3

# FIG.4

10

↓ L

11R (11)    11G (11)    11B (11)    11IR (11)

44    43R (43)    44    43G (43)    44    43B (43)    45    44

42
41
25
24
22
23
21

33
34
31

32

PD    PD    PD    PD

40
20
30

# FIG.5

# FIG.6

# FIG.7

# FIG.8

# FIG.9

# FIG.10

# FIG.11

# FIG.12

# FIG.13

# FIG.14

# FIG.15

# FIG.16

34a

# FIG.17

34b

# FIG.18

34b    34c

34a

# FIG.19

10

11R        11G        11B        11IR
(11)        (11)        (11)        (11)

L

44    43R    44    43G    44    43B    45    44
      (43)          (43)          (43)

42
41
25
24
22
23
21

PD    PD    PD    PD

40

20

33
34

31

30

32

# FIG.20

# FIG.21

# FIG.22

# FIG.23

# FIG.24

# FIG.25

# FIG.26

# FIG.27

# FIG.28

# FIG.29

# FIG.30

# FIG.31

# FIG.32

# FIG.33

# FIG.34

# FIG.35

# FIG.36

# FIG.37

# FIG.38

# FIG.39

# FIG.40

# FIG.41

# FIG.42

# FIG.43

# FIG.44

# FIG.45

# FIG.46

# FIG.47

# FIG.48

34

34d

# FIG.49

34

34d

# FIG.50

34

34d

# FIG.51

34

34d

# FIG.52

34

34d

# FIG.53

34

34d

# FIG.54

# FIG.55

# FIG.56

# FIG.57

# FIG.58

# FIG.59

# FIG.60

## FIG.61

## FIG.62

# FIG.63

# FIG.64

# FIG.65

EP 4 141 938 A1

# FIG.66

1

R1

R2

R3

# FIG.67

101

100

LENS GROUP

102
SOLID-STATE IMAGING ELEMENT

103
DSP CIRCUIT

105
DISPLAY UNIT

107
OPERA-TION UNIT

109

104
FRAME MEMORY

106
RECORD-ING UNIT

108
POWER SUPPLY UNIT

## INTERNATIONAL SEARCH REPORT

| International application No. |
| --- |
| **PCT/JP2021/015499** |

| A. | CLASSIFICATION OF SUBJECT MATTER |
| --- | --- |

*H01L 27/144*(2006.01)i; *H01L 27/146*(2006.01)i; *H04N 5/33*(2006.01)i
FI:   H01L27/146 D; H01L27/144 K; H04N5/33; H04N5/33 200

According to International Patent Classification (IPC) or to both national classification and IPC

| B. | FIELDS SEARCHED |
| --- | --- |

Minimum documentation searched (classification system followed by classification symbols)

H01L27/144; H01L27/146; H04N5/33

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2010-166094 A (SONY CORP.) 29 July 2010 (2010-07-29) paragraphs [0016]-[0053], [0065], [0066], fig. 1-5, 7 | 1-7, 16 |
| Y | | 8-15 |
| Y | JP 2006-261372 A (SONY CORP.) 28 September 2006 (2006-09-28) paragraphs [0018]-[0020], [0035]-[0042], fig. 1, 4 | 8 |
| Y | JP 2010-118412 A (PANASONIC CORP.) 27 May 2010 (2010-05-27) paragraphs [0011]-[0014], [0078]-[0087], fig. 1, 7 | 8, 9 |
| Y | JP 2010-147474 A (SAMSUNG ELECTRONICS CO., LTD.) 01 July 2010 (2010-07-01) paragraphs [0036]-[0041], fig. 25 | 9 |
| Y | WO 2018/079296 A1 (SONY SEMICONDUCTOR SOLUTIONS CORP.) 03 May 2018 (2018-05-03) paragraphs [0088], [0138]-[0143], fig. 31, 32 | 10, 11, 13 |
| Y | JP 2016-82133 A (SONY CORP.) 16 May 2016 (2016-05-16) paragraphs [0084]-[0119], fig. 3-6 | 10,11 |

| ✓ Further documents are listed in the continuation of Box C. | ✓ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **17 June 2021** | **06 July 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
| --- |
| **PCT/JP2021/015499** |

**C.      DOCUMENTS CONSIDERED TO BE RELEVANT**

| Category* | Citation of document, with indication, where appropriate, of the relevant passages | Relevant to claim No. |
| --- | --- | --- |
| Y | JP 2007-13147 A (TAIWAN SEMICONDUCTOR MFG CO., LTD.) 18 January 2007 (2007-01-18)<br>    paragraph [0023] | 11 |
| Y | JP 2010-56167 A (SONY CORP.) 11 March 2010 (2010-03-11)<br>    paragraphs [0043]-[0050], [0066]-[0076], fig. 1, 12 | 12 |
| Y | JP 2006-54262 A (SONY CORP.) 23 February 2006 (2006-02-23)<br>    paragraphs [0016]-[0050], fig. 1-6 | 14,15 |
| Y | WO 2018/043654 A1 (SONY SEMICONDUCTOR SOLUTIONS CORP.) 08 March 2018 (2018-03-08)<br>    paragraphs [0015]-[0021], fig. 1, 2 | 14,15 |
| A | JP 2008-147333 A (SONY CORP.) 26 June 2008 (2008-06-26)<br>    entire text, all drawings | 1-16 |
| A | WO 2013/172232 A1 (SONY CORP.) 21 November 2013 (2013-11-21)<br>    entire text, all drawings | 1-16 |
| A | JP 2014-86551 A (CANON KK) 12 May 2014 (2014-05-12)<br>    entire text, all drawings | 1-16 |
| A | JP 2012-64709 A (SONY CORP.) 29 March 2012 (2012-03-29)<br>    entire text, all drawings | 1-16 |
| A | JP 2010-62567 A (COMMISSARIAT A L'ENERGIE ATOMIQUE) 18 March 2010 (2010-03-18)<br>    entire text, all drawings | 1-16 |

Form PCT/ISA/210 (second sheet) (January 2015)

**INTERNATIONAL SEARCH REPORT**
Information on patent family members

International application No.

**PCT/JP2021/015499**

| Patent document cited in search report | | | Publication date (day/month/year) | Patent family member(s) | | | Publication date (day/month/year) |
|---|---|---|---|---|---|---|---|
| JP | 2010-166094 | A | 29 July 2010 | (Family: none) | | | |
| JP | 2006-261372 | A | 28 September 2006 | (Family: none) | | | |
| JP | 2010-118412 | A | 27 May 2010 | (Family: none) | | | |
| JP | 2010-147474 | A | 01 July 2010 | US | 2010/0148290 | A1 | |
| | | | | paragraphs [0067]-[0072], fig. 25 | | | |
| | | | | KR | 10-2010-0070094 | A | |
| WO | 2018/079296 | A1 | 03 May 2018 | US | 2019/0244992 | A1 | |
| | | | | paragraphs [0166], [0216]-[0219], fig. 31 | | | |
| | | | | KR | 10-2019-0067179 | A | |
| | | | | CN | 109906512 | A | |
| JP | 2016-82133 | A | 16 May 2016 | US | 2017/0229503 | A1 | |
| | | | | paragraphs [0164]-[0201], fig. 3-6 | | | |
| | | | | WO | 2016/063727 | A1 | |
| | | | | CN | 106796943 | A | |
| JP | 2007-13147 | A | 18 January 2007 | US | 2007/0001100 | A1 | |
| | | | | paragraph [0010] | | | |
| | | | | KR | 10-2007-0003658 | A | |
| | | | | CN | 1897287 | A | |
| | | | | TW | 200707714 | A | |
| JP | 2010-56167 | A | 11 March 2010 | US | 2010/0053400 | A1 | |
| | | | | paragraphs [0126]-[0140], [0177]-[0194], fig. 1, 12 | | | |
| | | | | CN | 101661946 | A | |
| | | | | KR | 10-2010-0024906 | A | |
| | | | | TW | 201010072 | A | |
| JP | 2006-54262 | A | 23 February 2006 | (Family: none) | | | |
| WO | 2018/043654 | A1 | 08 March 2018 | US | 2019/0206917 | A1 | |
| | | | | paragraphs [0093]-[0099], fig. 1, 2 | | | |
| | | | | EP | 3509106 | A1 | |
| | | | | CN | 109661727 | A | |
| JP | 2008-147333 | A | 26 June 2008 | US | 2008/0135963 | A1 | |
| | | | | entire text, all drawings | | | |
| | | | | KR | 10-2008-0053228 | A | |
| | | | | CN | 101197387 | A | |
| | | | | TW | 200836336 | A | |
| WO | 2013/172232 | A1 | 21 November 2013 | US | 2015/0123228 | A1 | |
| | | | | entire text, all drawings | | | |
| | | | | KR | 10-2015-0018775 | A | |
| | | | | CN | 104541371 | A | |
| JP | 2014-86551 | A | 12 May 2014 | US | 2014/0111663 | A1 | |
| | | | | entire text, all drawings | | | |
| JP | 2012-64709 | A | 29 March 2012 | US | 2012/0062777 | A1 | |
| | | | | entire text, all drawings | | | |
| | | | | CN | 102404514 | A | |
| | | | | KR | 10-2012-0028799 | A | |
| | | | | TW | 201220481 | A | |
| JP | 2010-62567 | A | 18 March 2010 | US | 2010/0059803 | A1 | |
| | | | | entire text, all drawings | | | |

Form PCT/ISA/210 (patent family annex) (January 2015)

## INTERNATIONAL SEARCH REPORT
### Information on patent family members

International application No.

**PCT/JP2021/015499**

| Patent document cited in search report | Publication date (day/month/year) | Patent family member(s) | | Publication date (day/month/year) |
|---|---|---|---|---|
| | | EP | 2161751 A1 | |
| | | FR | 2935839 A1 | |
| | | CN | 101667584 A | |

Form PCT/ISA/210 (patent family annex) (January 2015)

**REFERENCES CITED IN THE DESCRIPTION**

**Patent documents cited in the description**

- JP 2017139286 A